(19) Europäisches Patentamt / European Patent Office / Office européen des brevets

(11) **EP 2 511 314 A1**

(12) **EUROPÄISCHE PATENTANMELDUNG**

(43) Veröffentlichungstag:
**17.10.2012  Patentblatt 2012/42**

(51) Int Cl.:
*C08G 18/10* (2006.01)     *C08G 18/48* (2006.01)
*C08G 18/78* (2006.01)     *H01L 41/193* (2006.01)
*H01L 41/26* (2006.01)

(21) Anmeldenummer: **11161977.1**

(22) Anmeldetag: **12.04.2011**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**

(71) Anmelder: **Bayer MaterialScience AG**
**51368 Leverkusen (DE)**

(72) Erfinder:
• **Jenninger, Werner, Dr.**
**50677 Köln (DE)**
• **Wagner, Joachim, Dr.**
**51061 Köln (DE)**
• **Dörr, Sebastian, Dr.**
**40593 Düsseldorf (DE)**
• **Peiffer, Evelyn, Dr.**
**51375 Leverkusen (DE)**
• **Vogel, Stephanie, Dr.**
**40764 Langenfeld (DE)**
• **Nefzger, Hartmut, Dr.**
**50259 Pullheim (DE)**
• **Schmidt, Manfred, Dr.**
**41540 Dormagen (DE)**

(54)   **Polyurethanpolymer und dessen Verwendung in elektromechanischen Wandlern**

(57)   Die Erfindung betrifft einen elektromechanischer Wandler, umfassend ein durch eine erste Elektrode und eine zweite Elektrode kontaktiertes dielektrisches Elastomer, wobei das dielektrische Elastomer ein Polyurethanpolymer umfasst. Polyurethanpolymer ist erhältlich aus der Umsetzung eines Polyisocyanats und/oder Polyisocyanat-Prepolymers A) mit mindestens einer NCO-reaktiven Verbindung B), ein Verfahren zur Herstellung eines solchen elektromechanischen Wandlers sowie die Verwendung eines solchen elektromechanischen Wandlers.

EP 2 511 314 A1

**Beschreibung**

Die vorliegende Erfindung betrifft einen elektromechanischen Wandler, umfassend ein durch eine erste Elektrode und eine zweite Elektrode kontaktiertes dielektrisches Elastomer, wobei das dielektrische Elastomer ein Polyurethanpolymer umfasst. Die Erfindung betrifft weiterhin ein Verfahren zur Herstellung eines solchen elektromechanischen Wandlers, die Verwendung des eingesetzten dielektrischen Elastomers sowie eine elektrische und/oder elektronische Vorrichtung, umfassend einen erfindungsgemäßen elektromechanischen Wandler.

Polymerbasierte Aktuatoren, Sensoren oder Generatoren gewinnen eine zunehmende Bedeutung in elektromechanischen Wandlern. Als Beispiel hierfür seien die in WO 2001/006575 A1 genannten Systeme vorgestellt, welche vorgespannte Polymere einsetzen.

Hierbei liegt ein fortwährendes Interesse in der Weiterentwicklung der Polymermaterialien. WO 2008/095621 A1 beschäftigt sich mit rußgefüllten Polyurethanen, die sich durch eine hohe Dielektrizitätskonstante und Durchschlagfestigkeit auszeichnen. Sie sind aus Polyalkylenoxiden, die durch Doppelmetallcyanid-Katalyse hergestellt wurden, aufgebaut.

Energiewandler aus filmbildenden wässrigen Polyurethandispersionen werden in WO 2009/074192 offenbart. Auch hier werden die hohen Dielektrizitätskonstanten und die guten mechanischen Eigenschaften der erhaltenen Polyurethanfilme hervorgehoben.

WO 92/06139 A1 offenbart Polyurethan- und Polyharnstoffelastomere hergestellt aus Polyetherpolyolen mit niedrigem Monolgehalt, die nach dem Verfahren der Doppelmetallcyanid-Katalyse (DMC-Katalyse) hergestellt werden. Die daraus resultierenden PU-Elastomere weisen unterschiedliche Eigenschaften im Vergleich zu den PU-Elastomeren aus konventionell, durch KOH-Katalyse hergestellten Polyetherpolyolen auf.

Il Kim et al. (Polymer, Elsevier Science Publishers, Band 44, Nr. 11, (2003), Seiten 3417 - 3428) offenbart die DMC-katalysierte Polymerisation von Propylenoxid und die Anwendung der resultierenden Polyoxypropylenoxide in Polyurethanelastomeren, sowie deren mechanischen Eigenschaften.

EP 0 573 206 A1 offenbart die Herstellung von Isocyanat-terminierten Prepolymeren durch Reaktion von Polyisocyanat- und Polyetherpolyol-Mischungen. Die offenbarten Prepolymere können mit entsprechenden Verbindungen zur Kettenverlängerung zu Polyurethanen umgesetzt werden.

Ein häufiger Ausfallmechanismus von dielektrischen Elastomeren in elektromechanischen Wandlern ist mechanisches Versagen in Folge von Rissbildung. Dieses kann auf eine zu niedrige Bruchdehnung zurückgeführt werden. Wünschenswert sind daher für solche Einsatzzwecke verbesserte Polyurethanpolymere mit einer größeren Bruchdehnung und besonders hoher reversibler Deformierbarkeit.

Die Erfindung ist daher ein elektromechanischer Wandler, umfassend ein durch eine erste Elektrode und eine zweite Elektrode kontaktiertes dielektrisches Elastomer, wobei das dielektrische Elastomer ein Polyurethanpolymer umfasst. Der erfindungsgemäße Wandler zeichnet sich dadurch aus, dass das Polyurethanpolymer erhältlich ist aus der Umsetzung von

A) Polyisocyanat und/oder NCO-terminiertes Prepolymer, wobei das NCO-terminierte Prepolymer ausgewählt aus mindestens einem aus der Gruppe bestehend aus

A1) NCO-terminiertes Prepolymer basierend auf Polyisocyanat und Polyetherpolyol, wobei das Polyetherpolyol eine Funktionalität von 2, eine OH-Zahl von 3 mg KOH/g bis 150 mg KOH/g, bevorzugt von 3 mg KOH/g bis 60 mg KOH/g, besonders bevorzugt von 5 mg KOH/g bis 50 mg KOH/g, und einen durch Gelpermeationschromatographie in Tetrahydrofuran (THF) mit Polystyrolstandard als Kalibrierbeziehung bestimmten Polydispersitätsindex $M_w/M_n$ von > 1,0 bis ≤ 1,2, bevorzugt von > 1,0 bis ≤ 1,18, besonders bevorzugt von >1,0 bis ≤ 1,15 aufweist,

A2) NCO-terminiertes Prepolymer basierend auf Polyisocyanat und Polyetherpolyol, wobei das Polyetherpolyol eine Funktionalität von >2 bis 8, bevorzugt 3 bis 6, besonders bevorzugt 3 oder 4, eine OH-Zahl von 3 mg KOH/g bis 150 mg KOH/g, bevorzugt von 3 mg KOH/g bis 60 mg KOH/g, besonders bevorzugt von 5 mg KOH/g bis 50 mg KOH/g, und einen durch Gelpermeationschromatographie in Tetrahydrofuran (THF) mit Polystyrolstandard als Kalibrierbeziehung bestimmten Polydispersitätsindex $M_w/M_n$ von > 1,0 bis ≤ 1,2, bevorzugt von > 1,0 bis ≤ 1,18, besonders bevorzugt von >1,0 bis ≤ 1,15 aufweist,

A3) NCO-terminiertes Prepolymer mit Allophanat-, Biuret-, Isocyanurat-, Urethan- und/oder Harnstoff-Gruppen, basierend auf Polyisocyanat und Polyetherpolyol, wobei das Polyetherpolyol eine Funktionalität von 2, eine OH-Zahl von 3 mg KOH/g bis 150 mg KOH/g, bevorzugt von 3 mg KOH/g bis 60 mg KOH/g, besonders bevorzugt von 5 mg KOH/g bis 50 mg KOH/g, und einen durch Gelpermeationschromatographie in Tetrahydrofuran (THF) mit Polystyrolstandard als Kalibrierbeziehung bestimmten Polydispersitätsindex $M_w/M_n$ von > 1,0 bis ≤ 1,2, bevorzugt von > 1,0 bis ≤ 1,18, besonders bevorzugt von >1,0 bis ≤ 1,15 aufweist, und

A4) NCO-terminiertes Prepolymer mit Allophanat-, Biuret-, Isocyanurat-, Urethan- und/oder Harnstoff-Gruppen, basierend auf Polyisocyanat und Polyetherpolyol, wobei das Polyetherpolyol eine Funktionalität von >2 bis 8, bevorzugt 3 bis 6, besonders bevorzugt 3 oder 4, einer OH-Zahl von 3 mg KOH/g bis 150 mg KOH/g, bevorzugt von 3 mg KOH/g bis 60 mg KOH/g, besonders bevorzugt von 5 mg KOH/g bis 50 mg KOH/g, und einen durch Gelpermeationschromatographie in Tetrahydrofuran (THF) mit Polystyrolstandard als Kalibrierbeziehung bestimmten Polydispersitätsindex $M_w/M_n$ von > 1,0 bis ≤ 1,2, bevorzugt von > 1,0 bis ≤ 1,18, besonders bevorzugt von >1,0 bis ≤ 1,15 aufweist,
mit

B) mindestens einer NCO-reaktiven Verbindung ausgewählt aus der Gruppe bestehend aus

B1) Polyetherpolyol mit einer Funktionalität von 2, einer OH-Zahl von 3 mg KOH/g bis 150 mg KOH/g, bevorzugt von 3 mg KOH/g bis 60 mg KOH/g, besonders bevorzugt von 5 mg KOH/g bis 50 mg KOH/g, und einen durch Gelpermeationschromatographie in Tetrahydrofuran (THF) mit Polystyrolstandard als Kalibrierbeziehung bestimmten Polydispersitätsindex $M_w/M_n$ von > 1,0 bis ≤ 1,2, bevorzugt von > 1,0 bis ≤ 1,18, besonders bevorzugt von >1,0 bis ≤ 1,15,
B2) Polyetherpolyol mit einer Funktionalität >2 bis 8, bevorzugt 3 bis 6, besonders bevorzugt 3 oder 4, einer OH-Zahl von 3 mg KOH/g bis 150 mg KOH/g, bevorzugt von 3 mg KOH/g bis 60 mg KOH/g, besonders bevorzugt von 5 mg KOH/g bis 50 mg KOH/g, und einen durch Gelpermeationschromatographie in Tetrahydrofuran (THF) mit Polystyrolstandard als Kalibrierbeziehung bestimmten Polydispersitätsindex $M_w/M_n$ von > 1,0 bis ≤ 1,2, bevorzugt von > 1,0 bis ≤ 1,18, besonders bevorzugt von >1,0 bis ≤ 1,15,
B3) niedermolekulare, monomere Di-, Tri- und/oder Tetrole bzw. Di- und/oder Triamine,
wobei zur Herstellung der Komponente A) neben dem Polyetherpolyol keine weiteren gegenüber Isocyanaten reaktive Verbindungen eingesetzt werden;
wobei zur Herstellung des Polyurethanpolymers keine weiteren gegenüber Isocyanaten reaktive Verbindungen neben der Komponente B) eingesetzt werden, und
wobei mindestens eine der Komponenten A) und B) eine Funktionalität ≥ 3 aufweist,
wobei A1) bzw. A2) nicht in Mischungen mit einer weiteren Komponente A) eingesetzt wird,
wobei B1) und/oder B2) nicht in Mischungen mit B3) eingesetzt werden,
wobei im Falle einer Umsetzung von A3) mit B1) und/oder B2) das Molekulargewicht des Polyetherpolyols enthalten im Prepolymer A3) gleich dem Molekulargewicht der Komponente B1) und/oder gleich dem Äquivalentgewicht der Komponente B2) ist,
wobei im Falle einer Umsetzung von A4) mit B1) und/oder B2) das Äquivalentgewicht des Polyetherpolyols enthalten im Prepolymer A4) gleich dem Molekulargewicht der Komponente B1) und/oder gleich dem Äquivalentgewicht der Komponente B2) ist,
wobei im Falle einer Umsetzung von einer Mischung aus A3) und A4) mit B1) und/oder B2) das Molekulargewicht des Polyetherpolyols enthalten im Prepolymer A3) gleich dem Äquivalentgewicht des Polyetherpolyols enthalten im Prepolymer A4) gleich dem Molekulargewicht der Komponente B1) und/oder gleich dem Äquivalentgewicht der Komponente B2) ist.

Überraschenderweise wurde gefunden, dass die im erfindungsgemäßen elektromechanischen Wandler vorgesehenen Polyurethanpolymere gute elastomere Eigenschaften aufweisen und sich daher als dielektrische Elastomere in elektromechanischen Wandlern eignen. Insbesondere weisen diese Polyurethanpolymere eine hohe maximale, sehr reversible Dehnung auf, was einen vorteilhaften Einsatz in elektromechanischen Wandlern ergibt. Diese guten elastomeren und reversiblen Eigenschaften sind auf die sehr regelmäßige Struktur der Polyurethanpolymere zurückzuführen.
Im Sinne der Erfindung ist unter gleichem Molekulargewicht und/oder gleichem Äquivalentgewicht zu verstehen, wenn ausgehend von der größten in Rede stehenden Masse, die betreffenden anderen Massen wenigstens 70 %, bevorzugt wenigstens 80 %, besonders bevorzugt wenigstens 85 % der größten Masse erreichen, wobei mit Massen zahlengemittelte Molmassen gemeint sind.
Das NCO-terminierte Prepolymer A) ist erhältlich aus der Umsetzung von Polyisocyanaten mit Polyetherpolyolen. Zur Herstellung des NCO-terminierten Prepolymers A) werden keine weiteren isocyanatreaktiven Verbindungen neben den Polyetherpolyolen eingesetzt.
Als Polyisocyanat und/oder als Polyisocyanat zur Herstellung des NCO-terminierten Prepolymers A) eignen sich erfindungsgemäß beispielsweise 1,4-Butylendiisocyanat, 1,6 Hexamethylendiisocyanat (HDI), Isophorondiisocyanat (IPDI), 2,2,4 und/oder 2,4,4-Trimethylhexamethylendiisocyanat, die isomeren Bis-(4,4'-isocyanatocyclohexyl)methane oder deren Mischungen beliebigen Isomerengehalts, 1,4-Cyclohexylendiisocyanat, 4-Isocyanatomethyl-1,8-octandiisocyanat (Nonantriisocyanat), 1,4-Phenylendiisocyanat, 2,4- und/oder 2,6-Toluylendiisocyanat, 1,5-Naphthylendiisocyanat, 2,2'- und/oder 2,4'- und/oder 4,4'-Diphenylmethandiisocyanat, 1,3-und/oder 1,4-Bis-(2-isocyanato-prop-2-yl)-benzol (TMXDI), 1,3-Bis(isocyanatomethyl)benzol (XDI), Alkyl-2,6-diisocyanatohexanoate (Lysindiisocyanate) mit Alkylgruppen mit 1 bis 8 Kohlenstoffatomen sowie Mischungen davon. Weiterhin sind Uretdion-, Isocyanurat-, Biuret-, Iminooxadiazindion- oder Oxadiazintrionstruktur enthaltende Verbindungen basierend auf den genannten Diisocyanaten geeignete Bausteine zur Herstellung der Komponente A).

Bevorzugt werden als Polyisocyanate als Komponente A) Diisocyanate, Isocyanurate und/oder Biurete der bereits genannten Verbindungen eingesetzt, vorzugsweise solche basierend auf 1,6-Hexamethylendiisocyanat (HDI), Isophorondiisocyanat (IPDI), Bis-(4,4'-isocyanatocyclohexyl)-methan, Toluylendiisocyanat und/oder Diphenylmethandiisocyanat, besonders bevorzugt auf 1,6-Hexamethylendiisocyanat.

Als Polyisocyanate zur Herstellung des NCO-terminierten Prepolymers als Komponente A) werden bevorzugt 1,6- Hexamethylendiisocyanat (HDI) Isophorondiisocyanat (IPDI), Bis-(4,4'-isocyanatocyclohexyl)methan, Toluylendiisocyanat und/oder Diphenylmethandiisocyanat, besonders bevorzugt 1,6- Hexamethylendiisocyanat eingesetzt.

Die Funktionalität (d.h. Anzahl an Zerewitinoff-aktiven H-Atome pro Molekül) der Polyetherpolyole zum Aufbau des NCO-terminierten Prepolymers, sowie die Funktionalität der Polyetherpolyole, die als Komponente B) geeignet sind, bezieht sich auf die Funktionalität der H-funktionellen Starterverbindungen die zur Herstellung der Polyetherpolyole eingesetzt wurde.

Die Polyetherpolyole zum Aufbau des NCO-terminierten Prepolymers werden nach bekannten Verfahren durch ringöffnende Polymerisation von Alkylenoxiden unter Zusatz mindestens einer H-funktionellen Starterverbindung in Gegenwart eines Doppelmetallcyanid-Katalysators (DMC-Katalysators) hergestellt.

Unter den Alkylenoxiden sind Alkylenoxide (Epoxide) mit 2-24 Kohlenstoffatomen zu verstehen. Es handelt sich beispielsweise um eine oder mehrere Verbindungen ausgewählt aus der Gruppe bestehend aus Ethylenoxid, Propylenoxid, 1-Butenoxid, 2,3-Butenoxid, 2-Methyl-1,2-propenoxid (Isobutenoxid), 1-Pentenoxid, 2,3-Pentenoxid, 2-Methyl-1,2-butenoxid, 3-Methyl-1,2-butenoxid, 1-Hexenoxid, 2,3-Hexenoxid, 3,4-Hexenoxid, 2-Methyl-1,2-pentenoxid, 4-Methyl-1,2-pentenoxid, 2-Ethyl-1,2-butenoxid, 1-Heptenoxid, 1-Octenoxid, 1-Nonenoxid, 1-Decenoxid, 1-Undecenoxid, 1-Dodecenoxid, 4-Methyl-1,2-pentenoxid, Butadienmonoxid, Isoprenmonoxid, Cyclopentenoxid, Cyclohexenoxid, Cycloheptenoxid, Cyclooctenoxid, Styroloxid, Methylstyroloxid, Pinenoxid, ein-oder mehrfach epoxidierte Fette als Mono-, Di- und Triglyceride, epoxidierte Fettsäuren, $C_1$-$C_{24}$-Ester von epoxidierten Fettsäuren, Epichlorhydrin, Glycidol, und Derivate des Glycidols wie beispielsweise Methylglycidylether, Ethylglycidylether, 2-Ethylhexylglycidylether, Allylglycidylether, Glycidylmethacrylat sowie epoxidfunktionelle Alkyloxysilane wie beispielsweise 3-Glycidyloxypropyltrimethoxysilan, 3-Glycidyloxypropyltriethoxysilan, 3-Glycidyloxypropyltripropoxysilan, 3-Glycidyloxypropyl-methyl-dimethoxysilan, 3-Glycidyloxypropyl-ethyldiethoxysilan, 3-Glycidyloxypropyltriisopropoxysilan. Als Alkylenoxide werden bevorzugt Mischungen von Propylenoxid und Ethylenoxid eingesetzt, wobei der Anteil an Propylenoxid bei > 80 Gew.-% liegt, ganz besonders bevorzugt wird reines Propylenoxid eingesetzt.

H-funktionelle Starterverbindungen sind Verbindungen, die mindestens ein an N, O oder S gebundenes Wasserstoffatom enthalten. Diese Wasserstoffatome werden auch als Zerewitinoffaktiver Wasserstoff (manchmal auch nur als "aktiver Wasserstoff") bezeichnet, wenn er nach einem von Zerewitinoff aufgefundenen Verfahren durch Umsetzung mit Methylmagnesiumjodid Methan liefert. Typische Beispiele für Verbindungen mit Zerewitinoff-aktivem Wasserstoff sind Verbindungen, die Carboxyl-, Hydroxyl-, Amino-, Imino- oder Thiol-Gruppen als funktionelle Gruppen enthalten, besonders bevorzugt sind Hydroxylgruppen.

Geeignete H-funktionelle Starterverbindungen weisen meist Funktionalitäten von 2 bis 8 auf, bevorzugt von 2 bis 6, ganz besonders bevorzugt 2 bis 4. Ihre Molmassen betragen von 17 g/mol bis 1200 g/mol. Neben den bevorzugt zu verwendenden hydroxyfunktionellen Starterverbindungen können auch aminofunktionelle Starterverbindungen eingesetzt werden.

Beispiele für hydroxyfunktionelle Starterverbindungen sind Propylenglykol, Ethylenglykol, Diethylenglykol, Dipropylenglykol, 1,2-Butandiol, 1,3-Butandiol, 2,3-Butandiol, 1,4-Butandiol, 1,6-Hexandiol, 1,5-Pentandiol, 1,7-Heptandiol, 1,8-Octandiol, 1,9-Nonandiol, 1,10-Decandiol, 1,11-Undecandiol, 3-Methyl-1,5-pentandiol, 1,12-Dodecandiol, Glycerin, 1,1,1-Trimethylolpropan, Pentaerythrit, Sorbit, Saccharose, Hydrochinon, Brenzcatechin, Resorcin, Bisphenol F, Bisphenol A, 1,3,5-Trihydroxybenzol, sowie methylolgruppenhaltige Kondensate aus Formaldehyd und Phenol oder Harnstoff, sowie Wasser. Es können auch hochfunktionelle Starterverbindungen auf Basis von hydrierten Stärkehydrolyseprodukten eingesetzt werden. Solche sind beispielsweise in EP-A 1525244 beschrieben. Beispiele für geeignete aminogruppenhaltige H-funktionelle Starterverbindungen sind Ammoniak, Ethanolamin, Diethanolamin, Triethanolamin, Isopropanolamin, Diisopropanolamin, Ethylendiamin, Hexamethylendiamin, Cyclohexylamin, Diaminocyclohexan, Isophorondiamin, die Isomere des 1,8-p-Diaminomenthans, Anilin, die Isomere des Toluidins, die Isomere des Diaminotoluols, die Isomere des Diaminodiphenylmethans sowie bei der Kondensation von Anilin mit Formaldehyd zu Diaminodiphenylmethan anfallende höherkernige Produkte, ferner methylolgruppenhaltige Kondensate aus Formaldehyd und Melamin sowie Mannichbasen. Außerdem können als Starterverbindungen auch Ringöffnungsprodukte aus cyclischen Carbonsäureanhydriden und Polyolen eingesetzt werden. Beispiele sind Ringöffnungsprodukte aus Phthalsäureanhydrid, Bernsteinsäureanhydrid, Maleinsäureanhydrid einerseits und Ethylenglykol, Diethylenglykol, 1,2-Butandiol, 1,3-Butandiol, 1,4-Butandiol, 1,5-Pentandiol, 3-Methyl-1,5-pentandiol, 1,6-Hexandiol, 1,7-Heptandiol, 1,8-Octandiol, 1,9-Nonandiol, 1,10-Decandiol, 1,11-Undecandiol, 1,12-Dodecandiol, Glycerin, Trimethylolpropan, Pentaerythrit oder Sorbit andererseits.

Die H-funktionellen Starterverbindungen können auch aus der Substanzklasse der Polyetherpolyole ausgewählt sein, insbesondere solche mit einem Molekulargewicht Mn im Bereich von 100 bis 4000 g/mol. Bevorzugt sind Polyetherpolyole, die aus sich wiederholenden Ethylenoxid- und Propylenoxideinheiten aufgebaut sind, bevorzugt mit einem Anteil von 35 bis 100% Propylenoxideinheiten, besonders bevorzugt mit einem Anteil von 50 bis 100% Propylenoxideinheiten. Hierbei kann es sich um statistische Copolymere, Gradienten-Copolymere, alternierende oder Blockcopolymere aus Ethylenoxid und Propylenoxid handeln. Geeignete Polyetherpolyole, aufgebaut aus sich wiederholenden Propylenoxid- und/oder Ethylenoxideinheiten sind beispielsweise die Desmophen®-, Acclaim®-, Arcol®-, Baycoll®-, Bayfill®-, Bayflex®- Baygal®-, PET®- und Polyether-Polyole der Bayer MaterialScience AG (wie z. B. Desmophen® 3600Z, Desmophen® 1900U, Acclaim® Polyol 2200, Acclaim® Polyol 4000I, Arcol® Polyol 1004, Arcol® Polyol 1010, Arcol® Polyol 1030, Arcol® Polyol 1070, Baycoll® BD 1110, Bayfill® VPPU 0789, Baygal® K55, PET® 1004, Polyether® S180). Weitere geeignete homo-Polyethylenoxide sind beispielsweise die Pluriol® E-Marken der BASF SE, geeignete homo-Polypropylenoxide sind beispielsweise die Pluriol® P-Marken der BASF SE, geeignete gemischte Copolymere aus Ethylenoxid und Propylenoxid sind beispielsweise die Pluronic® PE oder Pluriol® RPE-Marken der BASF SE.

Die H-funktionellen Starterverbindungen werden entweder einzeln oder als Gemisch aus mindestens zwei H-funktionellen Starterverbindungen eingesetzt, bevorzugt wird eine einzige H-funktionelle Starterverbindung eingesetzt.

Besonders bevorzugt handelt es sich bei den H-funktionellen Starterverbindungen um eine oder mehrere Verbindungen ausgewählt aus der Gruppe bestehend aus Ethylenglykol, Propylenglykol, 1,3-Propandiol, 1,3-Butandiol, 1,4-Butandiol, 1,5-Pentandiol, 2-Methylpropan-1,3-diol, Neopentylglykol, 1,6-Hexandiol, 1,8 Octandiol, Diethylenglykol, Dipropylenglykol, Glycerin, Trimethylolpropan, di- und trifunktionelle Polyetherpolyole, wobei das Polyetherpolyol aus einer di-oder tri-H-funktionellen Starterverbindung und Propylenoxid bzw. einer di- oder tri-H-funktionellen Starterverbindung, Propylenoxid und Ethylenoxid aufgebaut ist. Die Polyetherpolyole haben bevorzugt ein Molekulargewicht Mn im Bereich von 62 bis 4500 g/mol und eine Funktionalität von 2 bis 3 und insbesondere ein Molekulargewicht Mn im Bereich von 62 bis 3000 g/mol und eine Funktionalität von 2 bis 3.

Bevorzugt wird das Polyetherpolyol zum Aufbau des NCO-terminierten Prepolymers durch Doppelmetallcyanid-Katalyse (DMC-Katalyse) hergestellt. DMC-Katalysatoren werden bei der Herstellung von Polyetherpolyolen durch Anlagerung von Alkylenoxiden an H-funktionelle Starterverbindungen, insbesondere Alkohole eingesetzt. Bei der Verwendung von DMC-Katalysatoren kann die Raum-Zeit-Ausbeute bei der Herstellung erhöht werden. Die nach diesem Verfahren hergestellten Polyetherpolyole zeichnen sich durch einen verringerten Gehalt an ungesättigten Bestandteilen aus. Weitere erreichbare Vorteile sind eine enge Molekularmassenverteilung und, beim Einsatz von Propylenoxid, ein überwiegender Anteil an sekundären OH-Endgruppen im Polyol.

Die Herstellung von DMC-Katalysatoren erfolgt üblicherweise durch Umsetzung einer Hexacyanometallatverbindung, vorzugsweise Hexacyanocobalt oder Hexacyanocobaltsäure, mit einem Metallsalz. Ein anderer Weg, der auch "Salzmetathese" genannt wird, verläuft über das Lösen eines Hexacyanometallatsalzes in Wasser und Ansäuern mit Schwefelsäure. Zu dieser Lösung wird ein organisches Lösungsmittel, beispielsweise Methanol, zugegeben, welches zur Ausfällung von Kaliumsulfat führt. Dieses wird abfiltriert und die auf diese Weise gewonnene Lösung der Hexacyanometallatsäure durch Vereinigung mit einer wässrigen Lösung der Metallsalzkomponente zum DMC-Katalysator umgesetzt. Bei dieser Umsetzung können Liganden und/oder organische Zusatzstoffe anwesend sein oder zugegeben werden.

Beispielsweise kann der DMC-Katalysator zur Herstellung der Polyetherpolyole zum Aufbau der NCO-terminierten Prepolymere neben einer Doppelmetallcyanid-Verbindung (z.B. Zinkhexacyanocobaltat(III)) und einem organischen Komplexliganden (z.B. tert.-Butanol) noch einen Polyether mit einem zahlenmittlerem Molekulargewicht größer als 500 g/mol enthalten, wie in EP-A 700949 beschrieben.

Die Polyetherpolyole zum Aufbau der NCO-terminierten Prepolymere weisen einen Polydispersitätsindex $M_w/M_n$ von > 1,0 bis ≤ 1,2, bevorzugt von > 1,0 bis ≤ 1,18, besonders bevorzugt von > 1,0 bis ≤ 1,15. $M_w$ und $M_n$ werden durch Gelpermeationschromatographie (GPC) in THF bestimmt, wobei als Kalibierbeziehung Polystyrol-Standards im relevanten Molekulargewichtsbereich verwendet werden.

Die OH-Zahl kann z. B. titrimetrisch nach der Vorschrift der DIN 53240 bestimmt werden.

Zur Herstellung des NCO-terminierten Prepolymers kann ein einziges Polyetherpolyol verwendet werden mit einer Funktionalität von 2 bis 8, bevorzugt 2 bis 6, besonders bevorzugt 2 bis 4, einer OH-Zahl von 3 mg KOH/g bis 150 mg KOH/g, bevorzugt von 3 mg KOH/g bis 60 mg KOH/g, besonders bevorzugt von 5 mg KOH/g bis 50 mg KOH/g, und einem durch Gelpermeationschromatographie in Tetrahydrofuran (THF) mit Polystyrolstandards als Kalibrierbeziehung bestimmten Polydispersitätsindex $M_w/M_n$ von > 1,0 bis ≤ 1,2, bevorzugt von > 1,0 bis ≤ 1,18, besonders bevorzugt von >1,0 bis ≤ 1,15.

Zur Herstellung des NCO-terminierten Prepolymers können auch verschiendene Polyetherpolyole verwendet werden mit jeweils einer Funktionalität von 2, jeweils einer OH-Zahl von 3 mg KOH/g bis 150 mg KOH/g, bevorzugt von 3 mg KOH/g bis 60 mg KOH/g, besonders bevorzugt von 5 mg KOH/g bis 50 mg KOH/g, und jeweils einen durch Gelpermeationschromatographie in Tetrahydrofuran (THF) mit Polystyrolstandard als Kalibrierbeziehung bestimmten

Polydispersitätsindex $M_w/M_n$ von > 1,0 bis ≤ 1,2, bevorzugt von > 1,0 bis ≤ 1,18, besonders bevorzugt von >1,0 bis ≤ 1,15, wobei die Polyetherpolyole jeweils die gleiche OH-Zahl aufweisen.

Zur Herstellung des NCO-terminierten Prepolymers können auch verschiendene Polyetherpolyole verwendet werden mit jeweils einer Funktionalität von >2 bis 8, bevorzugt 3 bis 6, besonders bevorzugt 3 oder 4, jeweils einer OH-Zahl von 3 mg KOH/g bis 150 mg KOH/g, bevorzugt von 3 mg KOH/g bis 60 mg KOH/g, besonders bevorzugt von 5 mg KOH/g bis 50 mg KOH/g, und jeweils einen durch Gelpermeationschromatographie in Tetrahydrofuran (THF) mit Polystyrolstandards als Kalibrierbeziehung bestimmten Polydispersitätsindex $M_w/M_n$ von > 1,0 bis ≤ 1,2, bevorzugt von > 1,0 bis ≤ 1,18, besonders bevorzugt von >1,0 bis ≤ 1,15, wobei die Polyetherpolyole jeweils die gleiche OH-Zahl aufweisen.

Zur Herstellung des NCO-terminierten Prepolymers können auch verschiendene Polyetherpolyole verwendet werden, mit jeweils einer OH-Zahl von 3 mg KOH/g bis 150 mg KOH/g, bevorzugt von 3 mg KOH/g bis 60 mg KOH/g, besonders bevorzugt von 5 mg KOH/g bis 50 mg KOH/g, jeweils einen durch Gelpermeationschromatographie in Tetrahydrofuran (THF) mit Polystyrolstandards als Kalibrierbeziehung bestimmten Polydispersitätsindex $M_w/M_n$ von > 1,0 bis ≤ 1,2, bevorzugt von > 1,0 bis ≤ 1,18, besonders bevorzugt von >1,0 bis ≤ 1,15, und wobei mindestens ein Polyetherpolyol eine Funktionalität von 2 aufweist und mindestens ein weiteres Polyetherpolyol eine Funktionalität >2 bis 8, bevorzugt 3 bis 6, besonders bevorzugt 3 oder 4 aufweist, und wobei jeweils die OH-Zahl des Polyetherpolyols mit einer Funktionalität von 2 doppelt so groß ist wie die OH-Zahl des weiteren Polyetherpolyols, also die Beziehung gemäß der Formel (I) gilt:

$$\text{OH-Zahl (Polyetherpolyol mit F =2) = 2 * OH-Zahl (Polyetherpolyol mit F>2)}$$

$$(I).$$

In einer Ausführungsform des elektromechanischen Wandlers ist das Polyisocyanat zur Herstellung des NCO-terminierten Prepolymers A) 1,6-Hexamethylendiisocyanat (HDI). Alternativ zu 1,6-Hexamethylendiisocyanat (HDI) können auch andere Diisocyanate eingesetzt werden, beispielsweise Isophorondiisocyanat (IPDI), Bis-(4,4'-isocyanatocyclohexyl)methan, Toluylendiisocyanat und/oder Diphenylmethandiisocyanat. Bevorzugt wird 1,6-Hexamethylendiisocyanat eingesetzt.

In einer weiteren Ausführungsform des elektromechanischen Wandlers weist das Polyetherpolyol zum Aufbau des NCO-terminierten Prepolymers eine Funktionalität von 2 bis 4 auf und enthält Propylenoxid-Anteile von mehr als 80 Gew.-%.

In einer Ausführungsform des erfindungsgemäßen elektromechanischen Wandlers weist das NCO-terminierte Prepolymer A) einen NCO-Gehalt von ≥ 1 Gewichts-% bis ≤ 8 Gewichts-% auf. Der NCO-Gehalt des Prepolymers lässt volumetrisch gemäß DIN-EN ISO 11909 bestimmen. Vorzugsweise liegt der NCO-Gehalt in einem Bereich von ≥ 1 Gewichts-% bis ≤ 6 Gewichts-%.

Das NCO-terminierte Prepolymer wird üblicherweise von überschüssigem monomeren Polyisocyanat befreit, bis der Anteil an freiem niedermolekularen monomeren Polyisocyanat < 0,1 Gew.-% beträgt. Bevorzugt erfolgt das Entfernen von monomeren Polyisocyanat durch kontinuierliche Destillation, besonders bevorzugt durch Dünnschichtdestillation.

Die Komponente B) dient der Kettenverlängerung und/oder Vernetzung des NCO-terminierten Prepolymers A).

Komponenten B1) und B2) sind Polyetherpolyole, die nach bekannten Verfahren durch ringöffnende Polymerisation von Alkylenoxiden unter Zusatz mindestens einer H-funktionellen Starterverbindung in Gegenwart eines Doppelmetallcyanid-Katalysators (DMC-Katalysators) hergestellt werden.

Unter den Alkylenoxiden sind Alkylenoxide (Epoxide) mit 2-24 Kohlenstoffatomen zu verstehen. Es handelt sich beispielsweise um eine oder mehrere Verbindungen ausgewählt aus der Gruppe bestehend aus Ethylenoxid, Propylenoxid, 1-Butenoxid, 2,3-Butenoxid, 2-Methyl-1,2-propenoxid (Isobutenoxid), 1-Pentenoxid, 2,3-Pentenoxid, 2-Methyl-1,2-butenoxid, 3-Methyl-1,2-butenoxid, 1-Hexenoxid, 2,3-Hexenoxid, 3,4-Hexenoxid, 2-Methyl-1,2-pentenoxid, 4-Methyl-1,2-pentenoxid, 2-Ethyl-1,2-butenoxid, 1-Heptenoxid, 1-Octenoxid, 1-Nonenoxid, 1-Decenoxid, 1-Undecenoxid, 1-Dodecenoxid, 4-Methyl-1,2-pentenoxid, Butadienmonoxid, Isoprenmonoxid, Cyclopentenoxid, Cyclohexenoxid, Cycloheptenoxid, Cyclooctenoxid, Styroloxid, Methylstyroloxid, Pinenoxid, ein- oder mehrfach epoxidierte Fette als Mono-, Di- und Triglyceride, epoxidierte Fettsäuren, $C_1$-$C_{24}$-Ester von epoxidierten Fettsäuren, Epichlorhydrin, Glycidol, und Derivate des Glycidols wie beispielsweise Methylglycidylether, Ethylglycidylether, 2-Ethylhexylglycidylether, Allylglycidylether, Glycidylmethacrylat sowie epoxidfunktionelle Alkyloxysilane wie beispielsweise 3-Glycidyloxypropyltrimethoxysilan, 3-Glycidyloxypropyltriethoxysilan, 3-Glycidyloxypropyltripropoxysilan, 3-Glycidyloxypropyl-methyl-dimethoxysilan, 3-Glycidyloxypropyl-ethyldiethoxysilan, 3-Glycidyloxypropyltriisopropoxysilan. Als Alkylenoxide werden bevorzugt Mischungen von Propylenoxid und Ethylenoxid eingesetzt, wobei der Anteil an Propylenoxid bei > 80 Gew.-% liegt, ganz besonders bevorzugt wird reines Propylenoxid eingesetzt.

H-funktionelle Starterverbindungen sind Verbindungen, die mindestens ein an N, O oder S gebundenes Wasserstoffatom enthalten. Diese Wasserstoffatome werden auch als Zerewitinoffaktiver Wasserstoff (manchmal auch nur als "aktiver Wasserstoff") bezeichnet, wenn er nach einem von Zerewitinoff aufgefundenen Verfahren durch Umsetzung mit Methylmagnesiumjodid Methan liefert. Typische Beispiele für Verbindungen mit Zerewitinoff-aktivem Wasserstoff sind Verbindungen, die Carboxyl-, Hydroxyl-, Amino-, Imino- oder Thiol-Gruppen als funktionelle Gruppen enthalten, besonders bevorzugt sind Hydroxylgruppen.

Geeignete H-funktionelle Starterverbindungen weisen meist Funktionalitäten von 2 bis 8 auf, bevorzugt von 2 bis 6, ganz besonders bevorzugt 2 bis 4. Ihre Molmassen betragen von 17 g/mol bis 1200 g/mol. Neben den bevorzugt zu verwendenden hydroxyfunktionellen Starterverbindungen können auch aminofunktionelle Starterverbindungen eingesetzt werden.

Beispiele für hydroxyfunktionelle Starterverbindungen sind Propylenglykol, Ethylenglykol, Diethylenglykol, Dipropylenglykol, 1,2-Butandiol, 1,3-Butandiol, 2,3-Butandiol, 1,4-Butandiol, 1,6-Hexandiol, 1,5-Pentandiol, 1,7-Heptandiol, 1,8-Octandiol, 1,9-Nonandiol, 1,10-Decandiol, 1,11-Undecandiol, 3-Methyl-1,5-pentandiol, 1,12-Dodecandiol, Glycerin, 1,1,1-Trimethylolpropan, Pentaerythrit, Sorbit, Saccharose, Hydrochinon, Brenzcatechin, Resorcin, Bisphenol F, Bisphenol A, 1,3,5-Trihydroxybenzol, sowie methylolgruppenhaltige Kondensate aus Formaldehyd und Phenol oder Harnstoff, sowie Wasser. Es können auch hochfunktionelle Starterverbindungen auf Basis von hydrierten Stärkehydrolyseprodukten eingesetzt werden. Solche sind beispielsweise in EP-A 1525244 beschrieben. Beispiele für geeignete aminogruppenhaltige H-funktionelle Starterverbindungen sind Ammoniak, Ethanolamin, Diethanolamin, Triethanolamin, Isopropanolamin, Diisopropanolamin, Ethylendiamin, Hexamethylendiamin, Cyclohexylamin, Diaminocyclohexan, Isophorondiamin, die Isomere des 1,8-p-Diaminomenthans, Anilin, die Isomere des Toluidins, die Isomere des Diaminotoluols, die Isomere des Diaminodiphenylmethans sowie bei der Kondensation von Anilin mit Formaldehyd zu Diaminodiphenylmethan anfallende höherkernige Produkte, ferner methylolgruppenhaltige Kondensate aus Formaldehyd und Melamin sowie Mannichbasen. Außerdem können als Starterverbindungen auch Ringöffnungsprodukte aus cyclischen Carbonsäureanhydriden und Polyolen eingesetzt werden. Beispiele sind Ringöffnungsprodukte aus Phthalsäureanhydrid, Bernsteinsäureanhydrid, Maleinsäureanhydrid einerseits und Ethylenglykol, Diethylenglykol, 1,2-Butandiol, 1,3-Butandiol, 1,4-Butandiol, 1,5-Pentandiol, 3-Methyl-1,5-pentandiol, 1,6-Hexandiol, 1,7-Heptandiol, 1,8-Octandiol, 1,9-Nonandiol, 1,10-Decandiol, 1,11-Undecandiol, 1,12-Dodecandiol, Glycerin, Trimethylolpropan, Pentaerythrit oder Sorbit andererseits.

Die H-funktionellen Starterverbindungen können auch aus der Substanzklasse der Polyetherpolyole ausgewählt sein, insbesondere solchen mit einem Molekulargewicht Mn im Bereich von 100 bis 4000 g/mol. Bevorzugt sind Polyetherpolyole, die aus sich wiederholenden Ethylenoxid- und Propylenoxideinheiten aufgebaut sind, bevorzugt mit einem Anteil von 35 bis 100% Propylenoxideinheiten, besonders bevorzugt mit einem Anteil von 50 bis 100% Propylenoxideinheiten. Hierbei kann es sich um statistische Copolymere, Gradienten-Copolymere, alternierende oder Blockcopolymere aus Ethylenoxid und Propylenoxid handeln. Geeignete Polyetherpolyole, aufgebaut aus sich wiederholenden Propylenoxid- und/oder Ethylenoxideinheiten sind beispielsweise die Desmophen®-, Acclaim®-, Arcol®-, Baycoll®-, Bayfill®-, Bayflex®- Baygal®-, PET®- und Polyether-Polyole der Bayer MaterialScience AG (wie z. B. Desmophen® 3600Z, Desmophen® 1900U, Acclaim® Polyol 2200, Acclaim® Polyol 4000I, Arcol® Polyol 1004, Arcol® Polyol 1010, Arcol® Polyol 1030, Arcol® Polyol 1070, Baycoll® BD 1110, Bayfill® VPPU 0789, Baygal® K55, PET® 1004, Polyether® S180). Weitere geeignete homo-Polyethylenoxide sind beispielsweise die Pluriol® E-Marken der BASF SE, geeignete homo-Polypropylenoxide sind beispielsweise die Pluriol® P-Marken der BASF SE, geeignete gemischte Copolymere aus Ethylenoxid und Propylenoxid sind beispielsweise die Pluronic® PE oder Pluriol® RPE-Marken der BASF SE.

Die H-funktionellen Starterverbindungen werden entweder einzeln oder als Gemisch aus mindestens zwei H-funktionellen Starterverbindungen eingesetzt, bevorzugt wird eine einzige H-funktionelle Starterverbindung eingesetzt.

Besonders bevorzugt handelt es sich bei den H-funktionellen Starterverbindungen um eine oder mehrere Verbindungen ausgewählt aus der Gruppe bestehend aus Ethylenglykol, Propylenglykol, 1,3-Propandiol, 1,3-Butandiol, 1,4-Butandiol, 1,5-Pentandiol, 2-Methylpropan-1,3-diol, Neopentylglykol, 1,6-Hexandiol, 1,8 Octandiol, Diethylenglykol, Dipropylenglykol, Glycerin, Trimethylolpropan, di- und trifunktionelle Polyetherpolyole, wobei das Polyetherpolyol aus einer di-oder tri-H-funktionellen Starterverbindung und Propylenoxid bzw. einer di- oder tri-H-funktionellen Starterverbindung, Propylenoxid und Ethylenoxid aufgebaut ist. Die Polyetherpolyole haben bevorzugt ein Molekulargewicht Mn im Bereich von 62 bis 4500 g/mol und eine Funktionalität von 2 bis 3 und insbesondere ein Molekulargewicht Mn im Bereich von 62 bis 3000 g/mol und eine Funktionalität von 2 bis 3.

Bevorzugt werden die Komponenten B1) und B2) durch Doppelmetallcyanid-Katalyse (DMC-Katalyse) hergestellt. DMC-Katalysatoren werden bei der Herstellung von Polyetherpolyolen durch Anlagerung von Alkylenoxiden an H-funktionelle Starterverbdindungen, insbesondere Alkohole eingesetzt. Bei der Verwendung von DMC-Katalysatoren kann die Raum-Zeit-Ausbeute bei der Herstellung erhöht werden. Die nach diesem Verfahren hergestellten Polyetherpolyole zeichnen sich durch einen verringerten Gehalt an ungesättigten Bestandteilen aus. Weitere erreichbare Vorteile sind eine enge Molekularmassenverteilung und, beim Einsatz von Propylenoxid, ein überwiegender Anteil an sekundären OH-Endgruppen im Polyol.

Die Herstellung von DMC-Katalysatoren erfolgt üblicherweise durch Umsetzung einer Hexacyanometallatverbindung, vorzugsweise Hexacyanocobaltat oder Hexacyanocobaltsäure, mit einem Metallsalz. Ein anderer Weg, der auch "Salzmetathese" genannt wird, verläuft über das Lösen eines Hexacyanometallatsalzes in Wasser und Ansäuern mit Schwefelsäure. Zu dieser Lösung wird ein organisches Lösungsmittel, beispielsweise Methanol, zugegeben, welches zur Ausfällung von Kaliumsulfat führt. Dieses wird abfiltriert und die auf diese Weise gewonnene Lösung der Hexacyanometallatsäure durch Vereinigung mit einer wässrigen Lösung der Metallsalzkomponente zum DMC-Katalysator umgesetzt. Bei dieser Umsetzung können Liganden und/oder organische Zusatzstoffe anwesend sein oder zugegeben werden.

Beispielsweise kann der DMC-Katalysator zur Herstellung der Komponenten B1) und B2) neben einer Doppelmetallcyanid-Verbindung (z.B. Zinkhexacyanocobaltat(III)) und einem organischen Komplexliganden (z.B. tert.-Butanol) noch einen Polyether mit einem zahlenmittlerem Molekulargewicht größer als 500 g/mol enthalten, wie in EP-A 700949 beschrieben.

Die Polyetherpolyole B1) und B2) weisen einen Polydispersitätsindex $M_w/M_n$ von > 1,0 bis ≤ 1,2, bevorzugt von > 1,0 bis ≤ 1,18, besonders bevorzugt von > 1,0 bis ≤ 1,15. $M_w$ und $M_n$ werden durch Gelpermeationschromatographie (GPC) in THF bestimmt, wobei als Kalibierbeziehung Polystyrol-Standards im relevanten Molekulargewichtsbereich verwendet werden.

Die OH-Zahl kann z. B. titrimetrisch nach der Vorschrift der DIN 53240 bestimmt werden.

Komponente B3) sind niedermolekulare monomere Di-, Tri- und/oder Tetrole bzw. Di- und/oder Triamine Monomere Di-, Tri-, und/oder Tetrole sind beispielsweise Ethylenglykol, Diethylenglykol, Triethylenglykol, Tetraethylenglykol, Dipropylenglykol, Tripropylenglykol, 1,2-Propandiol, 1,3-Propandiol, 1,4-Butandiol, 1,5-Pentandiol, 1,6-Hexandiol, 1,7-Heptandiol, 1,8-Octandiol, 1,9-Nonandiol, 1,10-Decandiol, 1,11 Undecandiol, 1,12 Dodecandiol, Neopentylglykol, 2-Ethyl-2-butylpropandiol, Trimethylpentandiol, 1,3-Butylenglykol, 1,4-Cyclohexandimethanol, 1,6-Hexandiol, 1,2- und 1,4-Cyclohexandiol, hydriertes Bisphenol A (2,2-Bis(4-hydroxycyclohexyl)propan), von Dimerfettsäuren abgeleitete Diole, 2,2-Dimethyl-3-hydroxypropionsäure-(2,2-dimethyl-3-hydroxypropylester), Glycerin, Trimethylolethan, Trimethylolpropan, Trimethylolbutan und/oder Rizinusöl. Bevorzugt sind Neopentylglykol, 1,4-Butandiol, 1,4-Cyclohexandimethanol, 1,6-Hexandiol, Pentaerythrit und/oder Trimethylolpropan. Monomere Di-und/oder Triamine sind beispielsweise Ethylendiamin, Propylendiamin, Butylendiamnin, Hexamethylendiamin, Octamethylendiamin, Decamethylendiamin, Dodecamethylendiamin, Piperazin.

Zur Herstellung des NCO-terminierten Prepolymers A) werden keine weiteren gegenüber Isocyanaten reaktive Verbindungen neben den Polyetherpolyolen eingesetzt. Zur Kettenverlängerung und/oder Vernetzung des NCO-terminierten Prepolymers A) werden keine weiteren gegenüber Isocyanaten reaktive Verbindungen neben Komponenten B) eingesetzt.

Im erfindungsgemäßen elektromechanischen Wandler weist mindestens eine der Komponenten A) und B) eine Funktionalität ≥ 3 auf, vorzugsweise ist die Komponente B) linear aufgebaut, weist also eine Funktionalität von 2 auf.

In einer Ausführungsform des elektromechanischen Wandlers ist das Polyurethanpolymer erhältlich aus der Reaktion eines NCO-terminierten Prepolymers A2) mit einem Polyetherpolyol B1).

In einer weiteren Ausführungsform des elektromechanischen Wandlers ist das Polyurethanpolymer erhältlich aus der Reaktion eines NCO-terminierten Prepolymers A3) mit einem Polyetherpolyol B1).

Werden im erfindungsgemäßen elektromechanischen Wandler zur Herstellung des Polyurethanpolymers vergleichsweise kurze Polyetherpolyole B1) und/oder B2) eingesetzt, erhält man Materialien mit einem höheren Modul, welche für Generatorik-Anwendungen von Interesse sind. Der Einsatz relativ langer Polyetherpolyole B1) und/oder B2) bewirkt weicheres Material, welches sich in der Aktorik besser eignet. Für Generatorik-Anwendungen werden bevorzugt Polyetherpolyole B1) und/oder B2) mit OH-Zahlen von 20 bis 102, bevorzugt 50 bis 70 basierend auf Startermolekülen mit einer Funktionalität von 2 bis 4, bevorzugt 2 bis 3 in den Polyurethanpolymeren eingesetzt. Für Aktorik-Anwendungen werden bevorzugt Polyetherpolyole B1) und/oder mit OH-Zahlen von 20 bis 102, bevorzugt 25 bis 56 basierend auf Startermolekülen mit einer Funktionalität von 2 bis 4, bevorzugt 2 bis 3 in den Polyurethanpolymeren eingesetzt.

In einer weiteren Ausführungsform des erfindungsgemäßen elektromechanischen Wandlers weist das Polyurethanpolymer eine maximale Dehnung von ≥ 200 % bis ≤ 550 % auf. Die maximale Dehnung oder Bruchdehnung wird anhand von DIN 53 504 und DIN 53 360 mit einer Zuggeschwindigkeit von 50 mm/min bestimmt. Vorzugsweise beträgt die maximale Dehnung ≥ 220 % bis ≤ 450 % und mehr bevorzugt ≥ 250 % bis ≤ 400 %.

Ein weiterer Gegenstand der vorliegenden Erfindung ist ein Verfahren zur Herstellung eines elektromechanischen Wandlers, umfassend die Schritte:

1) Bereitstellen einer ersten Elektrode und einer zweiten Elektrode;
2) Bereitstellen eines dielektrischen Elastomers, wobei das dielektrische Elastomer ein Polyurethanpolymer umfasst, und das Polyurethanpolymer erhältlich ist aus der Umsetzung von

A) Polyisocyanat und/oder NCO-terminiertes Prepolymer, wobei das NCO-terminierte Prepolymer ausgewählt aus mindestens einem aus der Gruppe bestehend aus

A1) NCO-terminiertes Prepolymer basierend auf Polyisocyanat und Polyetherpolyol, wobei das Polyetherpolyol eine Funktionalität von 2, eine OH-Zahl von 3 mg KOH/g bis 150 mg KOH/g, bevorzugt von 3 mg KOH/g bis 60 mg KOH/g, besonders bevorzugt von 5 mg KOH/g bis 50 mg KOH/g, und einen durch Gelpermeationschromatographie in Tetrahydrofuran (THF) mit Polystyrolstandard als Kalibrierbeziehung bestimmten Polydispersitätsindex $M_w/M_n$ von > 1,0 bis $\leq$ 1,2, bevorzugt von > 1,0 bis $\leq$ 1,18, besonders bevorzugt von >1,0 bis $\geq$ 1,15 aufweist,

A2) NCO-terminiertes Prepolymer basierend auf Polyisocyanat und Polyetherpolyol, wobei das Polyetherpolyol eine Funktionalität von >2 bis 8, bevorzugt 3 bis 6, besonders bevorzugt 3 oder 4, eine OH-Zahl von 3 mg KOH/g bis 150 mg KOH/g, bevorzugt von 3 mg KOH/g bis 60 mg KOH/g, besonders bevorzugt von 5 mg KOH/g bis 50 mg KOH/g, und einen durch Gelpermeationschromatographie in Tetrahydrofuran (THF) mit Polystyrolstandard als Kalibrierbeziehung bestimmten Polydispersitätsindex $M_w/M_n$ von > 1,0 bis $\leq$ 1,2, bevorzugt von > 1,0 bis $\leq$ 1,18, besonders bevorzugt von >1,0 bis $\leq$ 1,15 aufweist,

A3) NCO-terminiertes Prepolymer mit Allophanat-, Biuret-, Isocyanurat-, Urethan-und/oder Harnstoff-Gruppen, basierend auf Polyisocyanat und Polyetherpolyol, wobei das Polyetherpolyol eine Funktionalität von 2, eine OH-Zahl von 3 mg KOH/g bis 150 mg KOH/g, bevorzugt von 3 mg KOH/g bis 60 mg KOH/g, besonders bevorzugt von 5 mg KOH/g bis 50 mg KOH/g, und einen durch Gelpermeationschromatographie in Tetrahydrofuran (THF) mit Polystyrolstandard als Kalibrierbeziehung bestimmten Polydispersitätsindex $M_w/M_n$ von > 1,0 bis $\leq$ 1,2, bevorzugt von > 1,0 bis $\leq$ 1,18, besonders bevorzugt von >1,0 bis $\leq$ 1,15 aufweist, und

A4) NCO-terminiertes Prepolymer mit Allophanat-, Biuret-, Isocyanurat-, Urethan-und/oder Harnstoff-Gruppen, basierend auf Polyisocyanat und Polyetherpolyol, wobei das Polyetherpolyol eine Funktionalität von >2 bis 8, bevorzugt 3 bis 6, besonders bevorzugt 3 oder 4, einer OH-Zahl von 3 mg KOH/g bis 150 mg KOH/g, bevorzugt von 3 mg KOH/g bis 60 mg KOH/g, besonders bevorzugt von 5 mg KOH/g bis 50 mg KOH/g, und einen durch Gelpermeationschromatographie in Tetrahydrofuran (THF) mit Polystyrolstandard als Kalibrierbeziehung bestimmten Polydispersitätsindex $M_w/M_n$ von > 1,0 bis $\leq$ 1,2, bevorzugt von > 1,0 bis $\leq$ 1,18, besonders bevorzugt von >1,0 bis $\leq$ 1,15 aufweist, mit

B) mindestens einer NCO-reaktiven Verbindung ausgewählt aus der Gruppe bestehend aus

B1) Polyetherpolyol mit einer Funktionalität von 2, einer OH-Zahl von 3 mg KOH/g bis 150 mg KOH/g, bevorzugt von 3 mg KOH/g bis 60 mg KOH/g, besonders bevorzugt von 5 mg KOH/g bis 50 mg KOH/g, und einen durch Gelpermeationschromatographie in Tetrahydrofuran (THF) mit Polystyrolstandard als Kalibrierbeziehung bestimmten Polydispersitätsindex $M_w/M_n$ von > 1,0 bis $\leq$ 1,2, bevorzugt von > 1,0 bis $\leq$ 1,18, besonders bevorzugt von >1,0 bis $\leq$ 1,15,

B2) Polyetherpolyol mit einer Funktionalität >2 bis 8, bevorzugt 2 bis 6, besonders bevorzugt 2 bis 4, einer OH-Zahl von 3 mg KOH/g bis 150 mg KOH/g, bevorzugt von 3 mg KOH/g bis 60 mg KOH/g, besonders bevorzugt von 5 mg KOH/g bis 50 mg KOH/g, und einen durch Gelpermeationschromatographie in Tetrahydrofuran (THF) mit Polystyrolstandard als Kalibrierbeziehung bestimmten Polydispersitätsindex $M_w/M_n$ von > 1,0 bis $\leq$ 1,2, bevorzugt von > 1,0 bis $\leq$ 1,18, besonders bevorzugt von >1,0 bis $\leq$ 1,15,

B3) niedermolekulare, monomere Di-, Tri- und/oder Tetrole bzw. Di- und/oder Triamine,

wobei zur Herstellung der Komponente A) neben dem Polyetherpolyol keine weiteren gegenüber Isocyanaten reaktive Verbindungen eingesetzt werden;

wobei zur Herstellung des Polyurethanpolymers keine weiteren gegenüber Isocyanaten reaktive Verbindungen neben der Komponente B) eingesetzt werden, und

wobei mindestens eine der Komponenten A) und B) eine Funktionalität $\geq$ 3 aufweist, wobei A1) bzw. A2) nicht in Mischungen mit einer weiteren Komponente A) eingesetzt wird,

wobei B1) und/oder B2) nicht in Mischungen mit B3) eingesetzt werden,

wobei im Falle einer Umsetzung von A3) mit B1) und/oder B2) das Molekulargewicht des Polyetherpolyols enthalten im Prepolymer A3) gleich dem Molekulargewicht der Komponente B1) und/oder gleich dem Äquivalentgewicht der Komponente B2) ist,

wobei im Falle einer Umsetzung von A4) mit B1) und/oder B2) das Äquivalentgewicht des Polyetherpolyols enthalten im Prepolymer A4) gleich dem Molekulargewicht der Komponente B1) und/oder gleich dem Äquivalentgewicht der Komponente B2) ist,

wobei im Falle einer Umsetzung von einer Mischung aus A3) und A4) mit B1) und/oder B2) das Molekulargewicht des Polyetherpolyols enthalten im Prepolymer A3) gleich dem Äquivalentgewicht des Polyetherpolyols enthalten im Prepolymer A4) gleich dem Molekulargewicht der Komponente B1) und/oder gleich dem Äquivalentgewicht der Komponente B2) ist.

3) Anordnen des dielektrischen Elastomers zwischen die erste Elektrode und die zweite Elektrode.

Details zu dem Polyurethanpolymer einschließlich der Ausführungsformen wurden bereits vorstehend beschrieben. Zur Vermeidung von unnötigen Wiederholungen wird daher hierauf Bezug genommen.

Einsatzmöglichkeiten eines erfindungsgemäßen elektromechanischen Wandlers finden sich in einer Vielzahl von verschiedensten Anwendungen im elektromechanischen und elektroakustischen Bereich, insbesondere im Bereich der Energiegewinnung aus mechanischen Schwingungen ("Energy Harvesting"), der Akustik, des Ultraschalls, der medizinischen Diagnostik, der akustischen Mikroskopie, der mechanischen Sensorik, insbesondere Druck- Kraft- und/oder Dehnungssensorik, der Robotik und/oder der Kommunikationstechnologie. Typische Beispiele hierfür sind Drucksensoren, elektroakustische Wandler, Mikrophone, Lautsprecher, Schwingungswandler, Lichtdeflektoren, Membrane, Modulatoren für Glasfaseroptik, pyroelektrische Detektoren, Kondensatoren und Kontrollsysteme und "intelligente" Fußböden sowie Systeme zur Umwandlung von Wasserwellenenergie, insbesondere Meereswellenenergie, in elektrische Energie.

Wenn eine mechanische Beanspruchung auf einen derartigen Wandler ausgeübt wird, so deformiert sich der Wandler beispielsweise entlang seiner Dicke und seiner Fläche und ein starkes elektrisches Signal kann an den Elektroden detektiert werden. Damit wird mechanische Energie in elektrische Energie umgewandelt. Der erfindungsgemäße Wandler kann folglich sowohl als Generator als auch als Sensor eingesetzt werden.

Unter Ausnutzung des entgegengesetzten Effekts, nämlich der Umwandlung von elektrischer Energie in mechanische Energie, kann der erfindungsgemäße Wandler andererseits gleichermaßen als Aktuator dienen.

Als Elektroden sind grundsätzlich alle Materialien geeignet, welche eine ausreichen hohe elektrische Leitfähigkeit aufweisen und vorteilhafterweise der Ausdehnung des dielektrischen Elastomers folgen können. Beispielsweise können die Elektroden aus einem elektrisch leitfähigen Polymer, aus Leittinte oder aus Ruß aufgebaut sein.

Dielektrische Elastomere im Sinne der vorliegenden Erfindung sind Elastomere, die ihre Form durch das Anlegen eines elektrischen Feldes ändern können. Im Fall von Elastomerfolien kann sich zum Beispiel die Dicke verringern, während es gleichzeitig zu einer Längenausdehnung der Folie in Flächenrichtung kommt.

Die Dicke der dielektrischen Elastomerschicht beträgt vorzugsweise $\geq 1$ µm bis $\leq 500$ µm und mehr bevorzugt $\geq 10$ µm bis $\leq 100$ µm. Sie kann einstückig oder mehrstückig aufgebaut sein. Beispielsweise kann eine mehrstückige Schicht durch Aufeinanderlaminieren von einzelnen Schichten erhalten werden.

Das dielektrische Elastomer kann neben dem erfindungsgemäß vorgesehenen Polyurethanpolymer noch weitere Inhaltsstoffe aufweisen. Solche Inhaltsstoffe sind beispielsweise Vernetzer, Verdicker, Colösemittel, Thixotropiermittel, Stabilisatoren, Antioxidantien, Lichtschutzmittel, Emulgatoren, Tenside, Klebstoffe, Weichmacher, Hydrophobierungsmittel, Pigmente, Füllstoffe und Verlaufshilfsmittel.

Füllstoffe im Elastomer können beispielsweise die Dielektrizitätskonstante des Polymers regulieren. Beispiele hierfür sind keramische Füllstoffe, insbesondere Bariumtitanat, Titandioxid und piezoelektrische Keramiken wie Quarz oder Bleizirkoniumtitanat, sowie organische Füllstoffe, insbesondere solche mit einer hohen elektrischen Polarisierbarkeit, beispielsweise Phthalocyanine. Außerdem ist eine hohe Dielektrizitätskonstante auch durch das Einbringen elektrisch leitfähiger Füllstoffe unterhalb ihrer Perkolationsschwelle erzielbar. Beispiele hierfür sind Ruß, Graphit, einwandige oder mehrwandige Kohlenstoff-Nanoröhrchen, elektrisch leitfähige Polymere wie Polythiophene, Polyaniline oder Polypyrrole, oder Mischungen davon. In diesem Zusammenhang sind insbesondere solche Rußtypen von Interesse, die eine Oberflächenpassivierung aufweisen und deshalb bei niedrigen Konzentrationen unterhalb der Perkolationsschwelle zwar die Dielektrizitätskonstante erhöhen und trotzdem nicht zu einer Erhöhung der Leitfähigkeit des Polymers führen.

Im erfindungsgemäßen Verfahren erfolgt das Bereitstellen des dielektrischen Elastomers bevorzugt durch Auftragen der zu dem Polyurethanpolymer führenden Reaktionsmischung auf die erste und/oder zweite Elektrode. Der Vorteil dieser Vorgehensweise ist insbesondere, dass das aushärtende Elastomer eine gute Haftung zu den Elektroden aufbauen kann.

Das Auftragen der Reaktionsmischung kann beispielsweise durch Rakeln, Streichen, Gießen, Schleudern, Sprühen oder Extrusion erfolgen.

Vorzugsweise wird nach Auftragen der Reaktionsmischung getrocknet und/oder getempert. Das Trocknen/Tempern kann dabei in einem Temperaturbereich von 0 °C bis 200 °C, beispielsweise für 0,1 min bis 48 h, insbesondere für 6 h bis 18 h erfolgen; besonders bevorzugt ist eine Trocknung/Temperung für die Dauer von 15 min bis 30 min im Temperaturbereich von 60 °C bis 120 °C.

Die vorliegende Erfindung betrifft weiterhin die Verwendung eines dielektrischen Elastomers als Aktor, Sensor und/oder Generator in einem elektromechanischen Wandler, wobei das dielektrische Elastomer ein Polyurethanpolymer umfasst und das Polyurethanpolymer erhältlich ist aus der Umsetzung von

A) Polyisocyanat und/oder NCO-terminiertes Prepolymer, wobei das NCO-terminierte Prepolymer ausgewählt aus mindestens einem aus der Gruppe bestehend aus

A1) NCO-terminiertes Prepolymer basierend auf Polyisocyanat und Polyetherpolyol, wobei das Polyetherpolyol eine Funktionalität von 2, eine OH-Zahl von 3 mg KOH/g bis 150 mg KOH/g, bevorzugt von 3 mg KOH/g bis 60 mg KOH/g, besonders bevorzugt von 5 mg KOH/g bis 50 mg KOH/g, und einen durch Gelpermeationschromatographie in Tetrahydrofuran (THF) mit Polystyrolstandard als Kalibrierbeziehung bestimmten Polydispersitätsindex $M_w/M_n$ von > 1,0 bis $\leq$ 1,2, bevorzugt von > 1,0 bis $\leq$ 1,18, besonders bevorzugt von >1,0 bis $\leq$ 1,15 aufweist,

A2) NCO-terminiertes Prepolymer basierend auf Polyisocyanat und Polyetherpolyol, wobei das Polyetherpolyol eine Funktionalität von >2 bis 8, bevorzugt 3 bis 6, besonders bevorzugt 3 oder 4, eine OH-Zahl von 3 mg KOH/g bis 150 mg KOH/g, bevorzugt von 3 mg KOH/g bis 60 mg KOH/g, besonders bevorzugt von 5 mg KOH/g bis 50 mg KOH/g, und einen durch Gelpermeationschromatographie in Tetrahydrofuran (THF) mit Polystyrolstandard als Kalibrierbeziehung bestimmten Polydispersitätsindex $M_w/M_n$ von > 1,0 bis $\leq$ 1,2, bevorzugt von > 1,0 bis $\leq$ 1,18, besonders bevorzugt von >1,0 bis $\leq$ 1,15 aufweist,

A3) NCO-terminiertes Prepolymer mit Allophanat-, Biuret-, Isocyanurat-, Urethan- und/oder Harnstoff-Gruppen, basierend auf Polyisocyanat und Polyetherpolyol, wobei das Polyetherpolyol eine Funktionalität von 2, eine OH-Zahl von 3 mg KOH/g bis 150 mg KOH/g, bevorzugt von 3 mg KOH/g bis 60 mg KOH/g, besonders bevorzugt von 5 mg KOH/g bis 50 mg KOH/g, und einen durch Gelpermeationschromatographie in Tetrahydrofuran (THF) mit Polystyrolstandard als Kalibrierbeziehung bestimmten Polydispersitätsindex $M_w/M_n$ von > 1,0 bis $\leq$ 1,2, bevorzugt von > 1,0 bis $\leq$ 1,18, besonders bevorzugt von >1,0 bis $\leq$ 1,15 aufweist, und

A4) NCO-terminiertes Prepolymer mit Allophanat-, Biuret-, Isocyanurat-, Urethan- und/oder Harnstoff-Gruppen, basierend auf Polyisocyanat und Polyetherpolyol, wobei das Polyetherpolyol eine Funktionalität von >2 bis 8, bevorzugt 3 bis 6, besonders bevorzugt 3 oder 4, einer OH-Zahl von 3 mg KOH/g bis 150 mg KOH/g, bevorzugt von 3 mg KOH/g bis 60 mg KOH/g, besonders bevorzugt von 5 mg KOH/g bis 50 mg KOH/g, und einen durch Gelpermeationschromatographie in Tetrahydrofuran (THF) mit Polystyrolstandard als Kalibrierbeziehung bestimmten Polydispersitätsindex $M_w/M_n$ von > 1,0 bis $\leq$ 1,2, bevorzugt von > 1,0 bis $\leq$ 1,18, besonders bevorzugt von >1,0 bis $\leq$ 1,15 aufweist,

mit

B) mindestens einer NCO-reaktiven Verbindung ausgewählt aus der Gruppe bestehend aus

B1) Polyetherpolyol mit einer Funktionalität von 2, einer OH-Zahl von 3 mg KOH/g bis 150 mg KOH/g, bevorzugt von 3 mg KOH/g bis 60 mg KOH/g, besonders bevorzugt von 5 mg KOH/g bis 50 mg KOH/g, und einen durch Gelpermeationschromatographie in Tetrahydrofuran (THF) mit Polystyrolstandard als Kalibrierbeziehung bestimmten Polydispersitätsindex $M_w/M_n$ von > 1,0 bis $\leq$ 1,2, bevorzugt von > 1,0 bis $\leq$ 1,18, besonders bevorzugt von >1,0 bis $\leq$ 1,15,

B2) Polyetherpolyol mit einer Funktionalität >2 bis 8, bevorzugt 3 bis 6, besonders bevorzugt 3 oder 4, einer OH-Zahl von 3 mg KOH/g bis 150 mg KOH/g, bevorzugt von 3 mg KOH/g bis 60 mg KOH/g, besonders bevorzugt von 5 mg KOH/g bis 50 mg KOH/g, und einen durch Gelpermeationschromatographie in Tetrahydrofuran (THF) mit Polystyrolstandard als Kalibrierbeziehung bestimmten Polydispersitätsindex $M_w/M_n$ von > 1,0 bis $\leq$ 1,2, bevorzugt von > 1,0 bis $\leq$ 1,18, besonders bevorzugt von >1,0 bis $\leq$ 1,15,

B3) niedermolekulare, monomere Di-, Tri- und/oder Tetrole bzw. Di- und/oder Triamine,

wobei zur Herstellung der Komponente A) neben dem Polyetherpolyol keine weiteren gegenüber Isocyanaten reaktive Verbindungen eingesetzt werden;

wobei zur Herstellung des Polyurethanpolymers keine weiteren gegenüber Isocyanaten reaktive Verbindungen neben der Komponente B) eingesetzt werden, und

wobei mindestens eine der Komponenten A) und B) eine Funktionalität $\geq$ 3 aufweist,

wobei A1) bzw. A2) nicht in Mischungen mit einer weiteren Komponente A) eingesetzt wird,

wobei B1) und/oder B2) nicht in Mischungen mit B3) eingesetzt werden,

wobei im Falle einer Umsetzung von A3) mit B1) und/oder B2) das Molekulargewicht des Polyetherpolyols enthalten im Prepolymer A3) gleich dem Molekulargewicht der Komponente B1) und/oder gleich dem Äquivalentgewicht der Komponente B2) ist,

wobei im Falle einer Umsetzung von A4) mit B1) und/oder B2) das Äquivalentgewicht des Polyetherpolyols enthalten im Prepolymer A4) gleich dem Molekulargewicht der Komponente B1) und/oder gleich dem Äquivalentgewicht der Komponente B2) ist,

wobei im Falle einer Umsetzung von einer Mischung aus A3) und A4) mit B1) und/oder B2) das Molekulargewicht des Polyetherpolyols enthalten im Prepolymer A3) gleich dem Äquivalentgewicht des Polyetherpolyols enthalten im Prepolymer A4) gleich dem Molekulargewicht der Komponente B1) und/oder gleich dem Äquivalentgewicht der Komponente B2) ist.

Details zu dem Polyurethanpolymer einschließlich der Ausführungsformen wurden bereits im Zusammenhang mit dem erfindungsgemäßen elektromechanischen Wandler beschrieben. Zur Vermeidung von unnötigen Wiederholungen wird bezüglich dessen Verwendung hierauf Bezug genommen.

Ein weiterer Gegenstand der Erfindung ist eine elektrische und/oder elektronische Vorrichtung, umfassend einen erfindungsgemäßen elektromechanischen Wandler.

**Beispiele:**

Sofern nicht abweichend gekennzeichnet, beziehen sich alle Prozentangaben auf das Gewicht und alle analytischen Messungen beziehen sich auf Temperaturen von 23 °C. NCO-Gehalte wurden volumetrisch gemäß DIN-EN ISO 11909 bestimmt.

Die angegebenen Viskositäten wurden mittels Rotationsviskosimetrie nach DIN 53019 bei 23 °C einem Rotationsviskosimeter der Firma Anton Paar Germany GmbH bestimmt.

Die Zugversuche wurden mittels einer Zugmaschine der Firma Zwick, Modell Nummer 1455, ausgestattet mit einer Kraftmessdose des Gesamtmessbereiches 1kN nach DIN 53 504 und 53 360 mit einer Zuggeschwindigkeit von 50 mm/min ausgeführt. Als Probekörper wurden S2-Zugstäbe eingesetzt. Jede Messung wurde an drei gleichartig präparierten Probekörpern ausgeführt und der Mittelwert der erhaltenen Daten zur Bewertung verwendet. Zur Bewertung der erfindungsgemäßen Polymeren wurde die Bruchdehnung in [%] und die Reißfestigkeit in [N/mm$^2$] und die bleibende Dehnung [%] herangezogen.

Verwendete Substanzen und Abkürzungen:

PTHF 2000 -      Polytetrahydrofuran 2000, OH-Zahl= 56 mg KOH/g, BASF SE, Ludwigshafen, DE.
PTHF 2900 -      Polytetrahydrofuran 2900 OH-Zahl= 38, 5 mg KOH/g, BASF SE, Ludwigshafen, DE
Pripol 2033 -     Dimerdiol, CRODA, Nettetal, DE
DBTL            Dibutyl-Zinn-Dilaurat
Irganox® 1076:   Antioxidanz, Fa. BASF SE, Ludwigshafen, DE

**Beispiel 1: NCO-terminiertes Prepolymer**

1300 g Hexamethylen-1,6-diisocyanat (HDI), 1,3 g Benzoylchlorid und 1,3 g para-Toluolsulfonsäuremethylester wurden in einem 4 Liter Vierhalskolben unter Rühren vorgelegt. Innerhalb von 3 Stunden fügte man bei 80°C 1456 g eines difunktionellen Polypropylenoxid-Polyethers mit einer OH-Zahl von 56 mg KOH/g (hergestellt mittels DMC-Katalyse) und einem Polydispersitätsindex von 1,05 (Bayer MaterialScience AG, Leverkusen, DE) hinzu und rührte eine weitere Stunde bei gleicher Temperatur. Anschließend wurde durch Dünnschichtdestillation bei 130°C und 0,1 Torr das überschüssige HDI abdestilliert. Das erhaltene NCO-terminierte Prepolymer 1 hatte einen NCO-Gehalt von 3,23%, eine NCO-Funktionaliät von 2 und eine Viskosität von 1650 mPas (25°C).

**Beispiel 2: NCO-terminiertes Prepolymer**

1000 g Hexamethylen-1,6-diisocyanat und 0,15 g Zirkonoktoat wurden in einem 4 Liter Vierhalskolben unter Rühren vorgelegt. Dann fügte man bei 110°C 1000 g difunktionellen Polypropylenoxid-Polyether mit einer OH-Zahl von 28 mg KOH/g (hergestellt mittels DMC-Katalyse, und einem Polydispersitätsindex von 1,074 (Bayer MaterialScience AG, Leverkusen, DE) hinzu und rührte weitere 5 Stunden bei 110°C. Hierbei wurde 3 mal im Stundenabstand 0,15 g Zirkonoktoat zugesetzt. Nach Ablauf der Zeit wurden 0,15 g Dibutylphosphat und 0,5 g Benzoylchlorid zugesetzt. Anschließend wurde durch Dünnschichtdestillation bei 130°C und 0,1 Torr das überschüssige HDI abdestilliert. Das erhaltene NCO-Prepolymer 2 wies Allophanatgruppen auf, hatte einen NCO-Gehalt von 3,50 %, eine NCO-Funktionalität von 4 und eine Viskosität von 3980 mPas (25°C).

**Beispiel 3: NCO-terminiertes Prepolymer**

7,15 kg Diphenylmethan-4,4'-diisocyanat (MDI) wurden in einem Rührwerksbehälter bei einer Temperatur von 50°C vorgelegt und 45,85 kg eines trifunktionellen Polypropylenoxid-polyethylenoxid-Polyethers mit einer OH-Zahl von 28 mg KOH/g einem Polydispersitätsindex von 1,15 (hergestellt mittels DMC-Katalyse, Bayer MaterialScience LLC, Pittsburgh, USA) innerhalb von 15 min zugegeben. Wahlweise kann auch der trifunktionelle Polypropylenoxid-polyethylenoxid-Polyether bei 50°C vorgelegt werden und das auf 50°C erwärmte MDI zugegeben werden.

Danach wird zur Reaktion auf 100°C aufgeheizt und weitere 7 Stunden bei dieser Temperatur gerührt. Nach dem Abkühlen erhielt man das NCO-terminierte Prepolymer 3 mit einem NCO-Gehalt von 2,70 Gew.-%, einer NCO-Funktionalität von 3 und einer Viskosität bei 70°C von 4200 mPas.

**Beispiel 4: NCO-terminiertes Prepolymer**

1000 g Hexamethylen-1,6-diisocyanat (HDI) und 0,15 g Zirkonoktoat wurden in einem 4 Liter Vierhalskolben unter Rühren vorgelegt. Dann fügte man bei 110°C 1000 g PTHF 2000 hinzu und rührte weitere acht Stunden bei 110°C, wobei noch dreimal im Stundenabstand 0,15 g Zirkonoktoat zugesetzt wurden. Nach acht Stunden Reaktionszeit wurden 0,15 g Dibutylphosphat und 0,5 g Benzoylchlorid zugesetzt. Anschließend wurde durch Dünnschichtdestillation bei 130°C und 0,1 Torr das überschüssige HDI abdestilliert. Das erhaltene NCO-Prepolymer 4 wies Allophanatgruppen auf, hatte einen NCO-Gehalt von 6,2%, eine NCO-Funktionalität von 4 und eine Viskosität von 25700 mPas (25°C).

**Beispiel 5: NCO-terminiertes Prepolymer**

195 g eines Isocyanaurats auf Basis von Hexamethylendiisocyanat (NCO-Gehalt 21,8 $\pm$ 0,3 % nach DIN EN ISO 11 909, Viskosität 3000 $\pm$ 750 mPas der Fa. Bayer MaterialScience AG, Leverkusen, DE) wurden in einem 1 Liter Vierhalskolben unter Rühren vorgelegt. Dann fügte man bei 60°C 17,8 g 3-Hydroxypropionitril als monohydroxyfunktionellen Baustein hinzu und rührte 2 Tage bei 80°C. Die erhaltene NCO-Prepolymer 5 wies Allophanatgruppen auf, hatte einen NCO-Gehalt von 15,1 %, eine NCO-Funktionalität von 4 und eine Viskosität von 50000 mPas (25°C).

**Beispiel 6: Herstellung eines erfindungsgemäßen Polyurethanpolymers**

Die eingesetzten Rohstoffe wurden nicht separat entgast. 10 g des Prepolymeren aus Beispiel 2 wurde mit 16,4 g eines difunktionellen Polypropylenoxid-Polyethers mit einer OH-Zahl von 28 mg KOH/g und einem Polydispersitätsindex $M_w/M_n$ von 1,074 (Bayer MaterialScience AG, Leverkusen, DE) und mit 0,016 g DBTL in einem Polypropylen-Becher im Speedmixer bei 3000 Umdrehungen pro Minute für die Dauer von 3 Minuten vermischt. Aus dem noch flüssigen Reaktionsgemisch wurden auf Glasplatten von Hand Filme einer Nassschichtdicke von 1 mm gerakelt. Alle Filme wurden nach der Herstellung bei 80 °C im Trockenschrank über Nacht getrocknet und anschließend 5 min bei 120 °C nachgetempert. Die Filme konnten nach dem Tempern von Hand einfach von der Glasplatte gelöst werden. Die Werte zur Bruchdehnung und der bleibenden Dehnung sind Tabelle 1 zu entnehmen.

**Beispiel 7: Herstellung eines erfindungsgemäßen Polyurethanpolymers**

Die eingesetzten Rohstoffe wurden nicht separat entgast. 50 g des difunktionellen, linearen, aliphatischen Polycarbonatdiols mit endständigen Hydroxylgruppen und einer OH-Zahl von 56 mg KOH/g (Fa. Bayer MaterialScience AG, Leverkusen, DE) wurde mit 0,05g Irganox® 1076 in einem Polypropylenbecher auf 60 °C erwärmt und im Speedmixer für die Dauer von 3 min bei 3000 U/min vermischt. Nachdem der Stabilisator gelöst war, wurde 0,010 g DBTDL zugegeben und nochmals für die Dauer von 3 min bei 3000 U/min im Speedmixer gemischt. Zu dieser Mischung wurden 34,85 g des Prepolymeren aus Beispiel 3 gegeben und für die Dauer von 1 min bei 3000U/min im Speedmixer vermischt. Aus dem noch flüssigen Reaktionsgemisch wurden auf Glasplatten von Hand Filme einer Nassschichtdicke von 1 mm gerakelt. Alle Filme wurden nach der Herstellung bei 100 °C im Trockenschrank für die Dauer von 1 h getrocknet. Die Filme konnten nach dem Tempern von Hand einfach von der Glasplatte gelöst werden. Die Werte zur Bruchdehnung und der bleibenden Dehnung sind Tabelle 1 zu entnehmen.

**Beispiel 8: Herstellung eines erfindungsgemäßen Polyurethanpolymers**

Die eingesetzten Rohstoffe wurden nicht separat entgast. 50 g eines difunktionellen Polypropylenoxid-polyethylenoxid-Polyethers mit einer OH-Zahl von 28 mg KOH/g, einem Polydispersitätsindex von 1,074 und einem Anteil an Ethylenoxid-Einheiten von 20 Gew.-% (Bayer MaterialScience AG, Leverkusen, DE) wurden mit 0,115 g 1,4-Diazabicyclo [2.2.2]octan in einem Polypropylen-Becher im Speedmixer bei 3000 Umdrehungen pro Minute für die Dauer von 3 Minuten vermischt. Zu dem Gemisch wurden 43,32 g des Prepolymeren aus Beispiel 3 zugegeben und diese Mischung für 60 Sekunden im Speedmixer bei 3000 U/min vermischt. Aus dem noch flüssigen Reaktionsgemisch wurden auf Glasplatten von Hand Filme einer Nassschichtdicke von 1 mm gerakelt. Alle Filme wurden nach der Herstellung bei 80 °C im Trockenschrank für die Dauer von 12h getrocknet. Die Filme konnten von Hand einfach von der Glasplatte gelöst werden. Die Werte zur Bruchdehnung und der bleibenden Dehnung sind Tabelle 1 zu entnehmen.

**Beispiel 9 Herstellung eines erfindungsgemäßen Polyurethanpolymers**

Die eingesetzten Rohstoffe wurden nicht separat entgast. 76,92 g des difunktionellen, linearen, Polyesters mit endständigen Hydroxylgruppen und einer OH-Zahl von 56 mg KOH/g worden (Fa. Bayer MaterialScience AG, Leverkusen, DE) wurde mit 0,077g Irganox® 1076 in einem Polypropylenbecher auf 60 °C erwärmt und im Speedmixer für die Dauer von 3 min bei 3000 U/min vermischt. Nachdem der Stabilisator gelöst war, wurde 0,185 g Zinn(II)ethylhexanoat zugegeben und nochmals für die Dauer von 3 min bei 3000 U/min im Speedmixer gemischt. Zu dieser Mischung wurden 15,58 g eines Isocyanurats auf Basis von Hexamethylendiisocyanat (NCO-Gehalt 21,8 ± 0,3 % nach DIN EN ISO 11 909, Viskosität 3000 ± 750 mPas der Fa. Bayer MaterialScience AG, Leverkusen, DE) gegeben und für die Dauer von 1 min bei 3000U/min im Speedmixer vermischt. Aus dem noch flüssigen Reaktionsgemisch wurden auf Glasplatten von Hand Filme einer Nassschichtdicke von 1 mm gerakelt. Alle Filme wurden nach der Herstellung bei 100 °C im Trockenschrank für die Dauer von 1 h getrocknet. Die Filme konnten nach dem Tempern von Hand einfach von der Glasplatte gelöst werden. Die Werte zur Bruchdehnung und der bleibenden Dehnung sind Tabelle 1 zu entnehmen.

**Beispiel 10: Herstellung eines erfindungsgemäßen Polyurethanpolymers**

Die eingesetzten Rohstoffe wurden nicht separat entgast. 39,18 g eines difunktionellen, linearen, aliphatischen Polycarbonatdiols mit endständigen Hydroxylgruppen und einer OH-Zahl von 28 mg KOH/g (Bayer MaterialScience AG, Leverkusen, DE) wurde mit 0,039g Irganox® 1076 in einem Polypropylenbecher auf 70°C erwärmt und im Speedmixer für die Dauer von 3 min bei 3000 U/min vermischt. Nach Lösung des Stabilisators wurde 0,006 g DBTDL zugegeben und nochmals für die Dauer von 3 min bei 3000 U/min im Speedmixer gemischt. Zu dieser Mischung wurden 5 g des Prepolymeren aus Beispiel 5 und 5 g eines Isocyanurats auf Basis von Hexamethylendiisocyanat (NCO-Gehalt 21,8 ± 0,3 % nach DIN EN ISO 11 909, Viskosität 3000 ± 750 mPas der Fa. Bayer MaterialScience AG, Leverkusen, DE) gegeben und für die Dauer von 1 min bei 3000U/min im Speedmixer vermischt. Aus dem noch flüssigen Reaktionsgemisch wurden auf Glasplatten von Hand Filme einer Nassschichtdicke von 1 mm gerakelt. Alle Filme wurden nach der Herstellung bei 100 °C im Trockenschrank für die Dauer von 1 h getrocknet. Die Filme konnten nach dem Tempern von Hand einfach von der Glasplatte gelöst werden. Die Werte zur Bruchdehnung und der bleibenden Dehnung sind Tabelle 1 zu entnehmen.

**Beispiel 11: Herstellung eines Polyurethanpolymers (Vergleich)**

Die eingesetzten Rohstoffe wurden nicht separat entgast. 10 g des Prepolymeren aus Beispiel 2 wurde mit 2,028 g eines aminofunktionellen Bausteins mit OH-Zahl 226 mg KOH/g (Bayer MaterialScience AG, Leverkusen, DE) in einem Polypropylen-Becher im Speedmixer bei 3000 Umdrehungen pro Minute für die Dauer von 30 Sekunden vermischt. Aus dem noch flüssigen Reaktionsgemisch wurden auf Glasplatten von Hand Filme einer Nassschichtdicke von 1 mm gerakelt. Alle Filme wurden nach der Herstellung bei 80 °C im Trockenschrank über Nacht getrocknet. Die Filme konnten nach dem Tempern von Hand einfach von der Glasplatte gelöst werden. Die Werte zur Bruchdehnung und der bleibenden Dehnung sind Tabelle 1 zu entnehmen.

**Beispiel 12: Herstellung eines Polyurethanpolymers (Vergleich)**

Die eingesetzten Rohstoffe wurden nicht separat entgast. 30 g PTHF 2900 wurden mit 0,03 g DBTDL in einem Polypropylen-Becher im Speedmixer bei 3000 Umdrehungen pro Minute für die Dauer von 3 Minuten vermischt. Zu dem Gemisch wurden 15,67 g des Prepolymeren aus Beispiel 4 zugegeben und diese Mischung für 60 Sekunden im Speedmixer bei 3000 Umdrehungen pro Minute vermischt. Aus dem noch flüssigen Reaktionsgemisch wurden auf Glasplatten von Hand Filme einer Nassschichtdicke von 1 mm gerakelt. Alle Filme wurden nach der Herstellung bei 100 °C im Trockenschrank für die Dauer von 2h getrocknet. Die Filme konnten von Hand einfach von der Glasplatte gelöst werden. Die Werte zur Bruchdehnung und der bleibenden Dehnung sind Tabelle 1 zu entnehmen.

**Beispiel 13: Herstellung eines Polyurethanpolymers (Vergleich)**

Die eingesetzten Rohstoffe wurden nicht separat entgast. 10 g eines aliphatischen, Ethergruppen enthaltendes Preoplymer auf Basis von HDI mit Allophanatgruppen mit einem NCO-Gehalt von 6 % (DIN EN ISO 11 909), einer Viskosität von 2500 ± 750 mPas (Bayer MaterialScience AG, Leverkusen, DE) wurde mit 28,1 g eines difunktionellen Polypropylenoxid-Polyethers mit einer OH-Zahl von 28 mg KOH/g, einem Polydispersitätsindex von 1,074 (hergestellt mittels DMC-Katalyse) (Bayer MaterialScience AG, Leverkusen, DE) und mit 0,028 g DBTDL in einem Polypropylen-Becher im Speedmixer bei 3000 Umdrehungen pro Minute für die Dauer von 3 Minuten vermischt. Aus dem noch flüssigen Reaktionsgemisch wurden auf Glasplatten von Hand Filme einer Nassschichtdicke von 1 mm gerakelt. Alle Filme wurden nach der Herstellung bei 80 °C im Trockenschrank über Nacht getrocknet und anschließend 5 min bei 120 °C nachgetempert. Die Filme konnten nach dem Tempern von Hand einfach von der Glasplatte gelöst werden. Die Werte zur Bruchdehnung und der bleibenden Dehnung sind Tabelle 1 zu entnehmen.

**Beispiel 14: Herstellung eines Polyurethanpolymers (Vergleich)**

Die eingesetzten Rohstoffe wurden nicht separat entgast. 10 g eines difunktionellen Polypropylenoxid-Polyethers mit einer OH-Zahl von 56 mg KOH/g, einem Polydispersitätsindex von 1,1 (Bayer MaterialScience AG, Leverkusen, DE) wurden mit 0,01 g DBTDL in einem Polypropylen-Becher im Speedmixer bei 3000 Umdrehungen pro Minute für die Dauer von 3 Minuten vermischt. Zu dem Gemisch wurden 15,37 g eines aliphatischen, Ethergruppen enthaltendes Preoplymer auf Basis von HDI mit Allophanatgruppen mit einem NCO-Gehalt von 6 % (DIN EN ISO 11 909), einer Viskosität von 2500 $\pm$ 750 mPas (Fa. Bayer MaterialScience AG, Leverkusen, DE) zugegeben und diese Mischung für 30 Sekunden im Speedmixer bei 3000 U/min vermischt. Aus dem noch flüssigen Reaktionsgemisch wurden auf Glasplatten von Hand Filme einer Nassschichtdicke von 1 mm gerakelt. Alle Filme wurden nach der Herstellung bei 80 °C im Trockenschrank für die Dauer von 2h getrocknet. Die Filme konnten von Hand einfach von der Glasplatte gelöst werden. Die Werte zur Bruchdehnung und der bleibenden Dehnung sind Tabelle 1 zu entnehmen.

**Beispiel 15: Herstellung Polyurethanpolymers (Vergleich)**

Die eingesetzten Rohstoffe wurden nicht separat entgast. 10 g des Prepolymeren aus Beispiel 2 wurde mit 7,01 g eines difunktionellen Polypropylenoxid-Polyethers einer OH-Zahl von 56 mg KOH/g und einem Polydispersitätsindex $M_w/M_n$ von 1,07 mit 2,34 g eines trifunktionellen Polypropylenoxid-Polyethers mit einer OH-Zahl von 28 mg KOH/g und einem Polydispersitätsindex $M_w/M_n$ von 1,04 (Bayer MaterialScience AG, Leverkusen, DE) und mit 0,009 g DBTL in einem Polypropylen-Becher im Speedmixer bei 3000 Umdrehungen pro Minute für die Dauer von 3 Minuten vermischt. Aus dem noch flüssigen Reaktionsgemisch wurden auf Glasplatten von Hand Filme einer Nassschichtdicke von 1 mm gerakelt. Alle Filme wurden nach der Herstellung bei 80 °C im Trockenschrank über Nacht getrocknet und anschließend 5 min bei 120 °C nachgetempert. Die Filme konnten nach dem Tempern von Hand einfach von der Glasplatte gelöst werden. Die Werte zur Bruchdehnung und der bleibenden Dehnung sind Tabelle 1 zu entnehmen.

**Beispiel 16: Herstellung Polyurethanpolymers (Vergleich)**

Die eingesetzten Rohstoffe wurden nicht separat entgast. 10 g des Prepolymeren aus Beispiel 2 wurde mit 5,45 g eines difunktionellen Polypropylenoxid-Polyethers einer OH-Zahl von 56 mg KOH/g und einem Polydispersitätsindex $M_w/M_n$ von 1,07 (Bayer MaterialScience AG, Leverkusen, DE) mit 5,45 g eines trifunktionellen Polypropylenoxid-Polyethers mit einer OH-Zahl von 28 mg KOH/g und einem Polydispersitätsindex $M_w/M_n$ von 1,04 (Bayer MaterialScience AG, Leverkusen, DE) und mit 0,028 g DBTL in einem Polypropylen-Becher im Speedmixer bei 3000 Umdrehungen pro Minute für die Dauer von 3 Minuten vermischt. Aus dem noch flüssigen Reaktionsgemisch wurden auf Glasplatten von Hand Filme einer Nassschichtdicke von 1 mm gerakelt. Alle Filme wurden nach der Herstellung bei 80 °C im Trockenschrank über Nacht getrocknet und anschließend 5 min bei 120 °C nachgetempert. Die Filme konnten nach dem Tempern von Hand einfach von der Glasplatte gelöst werden. Die Werte zur Bruchdehnung und der bleibenden Dehnung sind Tabelle 1 zu entnehmen.

**Beispiel 17: Herstellung Polyurethanpolymers (Vergleich)**

Die eingesetzten Rohstoffe wurden nicht separat entgast. 20,5 g eines difunktionellen Polypropylenoxid-Polyethers mit einer OH-Zahl von 56 mg KOH/g und einem Polydispersitätsindex von 1,05 (Bayer MaterialScience AG, Leverkusen, DE) wurden mit 0,021g DBTDL in einem Polypropylen-Becher im Speedmixer bei 3000 Umdrehungen pro Minute für die Dauer von 3 Minuten vermischt. 14 g des Prepolymeren aus Beispiel 1 wurden mit 6 g eines Isocyanaurats auf Basis von Hexamethylendiisocyanat (NCO-Gehalt 21,8 $\pm$ 0,3 % nach DIN EN ISO 11 909, Viskosität 3000 $\pm$ 750 mPas der Fa. Bayer MaterialScience AG, Leverkusen, DE) in einem zweiten Polypropylenbecher eingewogen und für die Dauer von 3 Minuten bei 3000 U/min im Speedmixer vermischt. Zudem Polyolgemisch wurden 10g des Isocyanatgemisches gegeben und für die Dauer von 1 Minute bei 3000 U/min im Speedmixer gemischt.Aus dem noch flüssigen Reaktionsgemisch wurden auf Glasplatten von Hand Filme einer Nassschichtdicke von 1 mm gerakelt. Alle Filme wurden nach der Herstellung bei 80 °C im Trockenschrank für die Dauer von 12 h gehärtet. Die Filme konnten nach dem Tempern von Hand einfach von der Glasplatte gelöst werden. Die Werte zur Bruchdehnung und der bleibenden Dehnung sind Tabelle 1 zu entnehmen.

**Beispiel 18: Herstellung Polyurethanpolymers (Vergleich)**

Die eingesetzten Rohstoffe wurden nicht separat entgast. 50,45 g eines difunktionellen Polypropylenoxid-polyethylenoxid-Polyethers mit einer OH-Zahl von 28 mg KOH/g, einem Polydispersitätsindex von 1,07 und einem Anteil von Ethylenoxid-Einheiten von 20 Gew.-% (Bayer MaterialScience AG, Leverkusen, DE) wurden mit 0,05g Irganox® 1076 und mit 0,404 g DBTDL in einem Polypropylen-Becher im Speedmixer bei 3000 Umdrehungen pro Minute für die Dauer von 3 Minuten vermischt. 21 g des Prepolymeren aus Beispiel 1 wurden mit 9 g eines Isocyanaurats auf Basis von Hexamethylendiisocyanat (NCO-Gehalt 21,8 ± 0,3 % nach DIN EN ISO 11 909, Viskosität 3000 ± 750 mPas der Fa. Bayer MaterialScience AG, Leverkusen, DE) in einem zweiten Polypropylenbecher eingewogen und für die Dauer von 3 Minuten bei 3000 U/min im Speedmixer vermischt. Zudem Polyolgemisch des ersten Polypropylenbechers wurden 15g des Isocyanatgemisches gegeben und für die Dauer von 1 Minute bei 3000 Umdrehungen pro Minute im Speedmixer gemischt. Aus dem noch flüssigen Reaktionsgemisch wurden auf Glasplatten von Hand Filme einer Nassschichtdicke von 1 mm gerakelt. Alle Filme wurden nach der Herstellung bei 100 °C im Trockenschrank für die Dauer von 2 h gehärtet. Die Filme konnten nach dem Tempern von Hand einfach von der Glasplatte gelöst werden. Die Werte zur Bruchdehnung und der bleibenden Dehnung sind Tabelle 1 zu entnehmen.

**Beispiel 19: Herstellung Polyurethanpolymers (Vergleich)**

100 g PTHF 2000 und 0,003g DBTDL wurden in einen Polypropylenbecher eingewogen und für 5 min bei 3000 Umdrehungen pro Minute im Speedmixer vermischt. 15 g des Prepolymeren aus Beispiel 3 wurden mit 15 g eines Isocyanaurats auf Basis von Hexamethylendiisocyanat (NCO-Gehalt 21,8 ± 0,3 % nach DIN EN ISO 11 909, Viskosität 3000 ± 750 mPas der Fa. Bayer MaterialScience AG, Leverkusen, DE) in einem zweiten Polypropylenbecher zusammen eingewogen und für die Dauer von 5 min bei 3000 Umdrehungen pro Minute im Speedmixer vermischt. Zu dem Isocyanatgemisch im zweiten Polypropylenbecher wurden 89,452 g der Polyolmischung des ersten Polypropylenbechers hinzugegeben und für die Dauer von 1 min bei 3000 Umdrehungen pro Minute im Speedmixer vermischt. Aus dem noch flüssigen Reaktionsgemisch wurden auf Glasplatten von Hand Filme einer Nassschichtdicke von 1 mm gerakelt. Alle Filme wurden nach der Herstellung bei 100 °C im Trockenschrank für die Dauer von 2 h getrocknet. Die Filme konnten nach dem Tempern von Hand einfach von der Glasplatte gelöst werden. Die Werte zur Bruchdehnung und der bleibenden Dehnung sind Tabelle 1 zu entnehmen.

**Beispiel 20: Herstellung Polyurethanpolymers (Vergleich)**

Die eingesetzten Rohstoffe wurden nicht separat entgast. 10 g Pripol® 2033 und 0,01 g DBTDL wurden in einen Polypropylenbecher eingewogen und für die Dauer von 1 Minute bei 3000 Umdrehungen pro Minute vermischt. Zu dieser Mischung wurden 7,36 g eines Isocyanaurats auf Basis von Hexamethylendiisocyanat (NCO-Gehalt 21,8 ± 0,3 % nach DIN EN ISO 11 909, Viskosität 3000 ± 750 mPas der Fa. Bayer MaterialScience AG, Leverkusen, DE) zugegeben und im Speedmixer bei 3000 Umdrehungen pro Minute für die Dauer von 30 Sekunden vermischt. Aus dem noch flüssigen Reaktionsgemisch wurden auf Glasplatten von Hand Filme einer Nassschichtdicke von 1 mm gerakelt. Alle Filme wurden nach der Herstellung bei 80 °C im Trockenschrank über Nacht getrocknet. Die Filme konnten nach dem Tempern von Hand einfach von der Glasplatte gelöst werden. Die Werte zur Bruchdehnung und der bleibenden Dehnung sind Tabelle 1 zu entnehmen.

**Beispiel 21: Herstellung Polyurethanpolymers (Vergleich)**

Die eingesetzten Rohstoffe wurden nicht separat entgast. 5 g des Prepolymeren aus Beispiel 1 wurde mit 5 g des Prepolymeren aus Beispiel 2 im Polypropylenbecher eingewogen und für die Dauer von 1 Minute bei 3000 Umdrehungen pro Minute vermischt. Zu dieser Mischung wurden 1,956 g eines aminofunktionellen Bausteins mit OH-Zahl 226 mg KOH/g (Bayer MaterialScience AG, Leverkusen, DE) zugegeben und im Speedmixer bei 3000 Umdrehungen pro Minute für die Dauer von 30 Sekunden vermischt. Aus dem noch flüssigen Reaktionsgemisch wurden auf Glasplatten von Hand Filme einer Nassschichtdicke von 1 mm gerakelt. Alle Filme wurden nach der Herstellung bei 80 °C im Trockenschrank über Nacht getrocknet. Die Filme konnten nach dem Tempern von Hand einfach von der Glasplatte gelöst werden. Die Werte zur Bruchdehnung und der bleibenden Dehnung sind Tabelle 1 zu entnehmen.

Tabelle 1: Messwerte der Dehnungen in den Polyurethanen der Beispiele 6-21

| Beispiel | Bruchdehnung [%] | bleibende Dehnung (75%) [%] | bleibende Dehnung (100%) [%] |
|---|---|---|---|
| 6 | 255 | 0 | 0 |
| 7 | 359 | 2,7 | 3,5 |
| 8 | 275 | 1,6 | 2,8 |
| 9 | 323 | 0,3 | 0,5 |
| 10 | 219 | 0,4 | 0,6 |
| 11 (Vergleich) | 86 | - | - |
| 12 (Vergleich) | 83 | - | - |
| 13 (Vergleich) | 125 | 0,5 | 0,7 |
| 14 (Vergleich) | 40 | - | - |
| 15 (Vergleich) | 146 | 2,3 | 2,8 |
| 16 (Vergleich) | 160 | 0,7 | 1 |
| 17 (Vergleich) | 102 | 0,8 | 1,1 |
| 18 (Vergleich) | 95 | 0,5 | - |
| 19 (Vergleich) | 108 | 0,8 | - |
| 20 (Vergleich) | 94 | - | - |
| 21 (Vergleich) | 134 | 0,4 | 2,9 |

## Patentansprüche

1. Elektromechanischer Wandler, umfassend ein durch eine erste Elektrode und eine zweite Elektrode kontaktiertes dielektrisches Elastomer, wobei das dielektrische Elastomer ein Polyurethanpolymer umfasst, **dadurch gekennzeichnet, dass** das Polyurethanpolymer erhältlich ist aus der Umsetzung von

A) Polyisocyanat und/oder NCO-terminiertes Prepolymer, wobei das NCO-terminierte Prepolymer ausgewählt aus mindestens einem aus der Gruppe bestehend aus

A1) NCO-terminiertes Prepolymer basierend auf Polyisocyanat und Polyetherpolyol, wobei das Polyetherpolyol eine Funktionalität von 2, eine OH-Zahl von 3 mg KOH/g bis 150 mg KOH/g und einen durch Gelpermeationschromatographie in Tetrahydrofuran (THF) mit Polystyrolstandards als Kalibrierbeziehung bestimmten Polydispersitätsindex $M_w/M_n$ von > 1,0 bis $\leq$ 1,2 aufweist,
A2) NCO-terminiertes Prepolymer basierend auf Polyisocyanat und Polyetherpolyol, wobei das Polyetherpolyol eine Funktionalität von >2 bis 8, eine OH-Zahl von 3 mg KOH/g bis 150 mg KOH/g und einen durch Gelpermeationschromatographie in Tetrahydrofuran (THF) mit Polystyrolstandards als Kalibrierbeziehung bestimmten Polydispersitätsindex $M_w/M_n$ von > 1,0 bis $\leq$ 1,2 aufweist,
A3) NCO-terminiertes Prepolymer mit Allophanat-, Biuret-, Isocyanurat-, Urethan- und/oder Harnstoff-Gruppen, basierend auf Polyisocyanat und Polyetherpolyol, wobei das Polyetherpolyol eine Funktionalität von 2, eine OH-Zahl von 3 mg KOH/g bis 150 mg KOH/g und einen durch Gelpermeationschromatographie in Tetrahydrofuran (THF) mit Polystyrolstandards als Kalibrierbeziehung bestimmten Polydispersitätsindex $M_w/M_n$ von > 1,0 bis $\leq$ 1,2 aufweist, und A4) NCO-terminiertes Prepolymer mit Allophanat-, Biuret-, Isocyanurat-, Urethan- und/oder Harnstoff-Gruppen, basierend auf Polyisocyanat und Polyetherpolyol, wobei das Polyetherpolyol eine Funktionalität von >2 bis 8, einer OH-Zahl von 3 mg KOH/g bis 150 mg KOH/g und einen durch Gelpermeationschromatographie in Tetrahydrofuran (THF) mit Polystyrolstandards als Kalibrierbeziehung bestimmten Polydispersitätsindex $M_w/M_n$ von > 1,0 bis $\leq$ 1,2 aufweist,
mit

B) mindestens einer NCO-reaktiven Verbindung ausgewählt aus der Gruppe bestehend aus B1) Polyetherpolyol mit einer Funktionalität von 2, einer OH-Zahl von 3 mg KOH/g bis 150 mg KOH/g und einen durch Gelpermeationschromatographie in Tetrahydrofuran (THF) mit Polystyrolstandards als Kalibrierbeziehung bestimmten Polydispersitätsindex $M_w/M_n$ von > 1,0 bis $\leq$ 1,2,

B2) Polyetherpolyol mit einer Funktionalität >2 bis 8, bevorzugt 2 bis 6, besonders bevorzugt 2 bis 4, einer OH-Zahl von 3 mg KOH/g bis 150 mg KOH/g und einen durch Gelpermeationschromatographie in Tetrahydrofuran (THF) mit Polystyrolstandards als Kalibrierbeziehung bestimmten Polydispersitätsindex $M_w/M_n$ von > 1,0 bis ≤ 1,2,

B3) niedermolekulare, monomere Di-, Tri- und/oder Tetrole bzw. Di- und/oder Triamine,

wobei zur Herstellung der Komponente A) neben dem Polyetherpolyol keine weiteren gegenüber Isocyanaten reaktive Verbindungen eingesetzt werden;

wobei zur Herstellung des Polyurethanpolymers keine weiteren gegenüber Isocyanaten reaktive Verbindungen neben der Komponente B) eingesetzt werden, und

wobei mindestens eine der Komponenten A) und B) eine Funktionalität ≥ 3 aufweist,

wobei A1) bzw. A2) nicht in Mischungen mit einer weiteren Komponente A) eingesetzt wird,

wobei B1) und/oder B2) nicht in Mischungen mit B3) eingesetzt werden,

wobei im Falle einer Umsetzung von A3) mit B1) und/oder B2) das Molekulargewicht des Polyetherpolyols enthalten im Prepolymer A3) gleich dem Molekulargewicht der Komponente B1) und/oder gleich dem Äquivalentgewicht der Komponente B2) ist,

wobei im Falle einer Umsetzung von A4) mit B1) und/oder B2) das Äquivalentgewicht des Polyetherpolyols enthalten im Prepolymer A4) gleich dem Molekulargewicht der Komponente B1) und/oder gleich dem Äquivalentgewicht der Komponente B2) ist,

wobei im Falle einer Umsetzung von einer Mischung aus A3) und A4) mit B1) und/oder B2) das Molekulargewicht des Polyetherpolyols enthalten im Prepolymer A3) gleich dem Äquivalentgewicht des Polyetherpolyols enthalten im Prepolymer A4) gleich dem Molekulargewicht der Komponente B1) und/oder gleich dem Äquivalentgewicht der Komponente B2) ist.

2. Elektromechanischer Wandler gemäß Anspruch 1, wobei das Polyisocyanat zur Herstellung des Prepolymers A) 1,6-Hexamethylendiisocyanat ist.

3. Elektromechanischer Wandler gemäß Anspruch 1 oder 2, wobei das Prepolymer A) einen NCO-Gehalt von ≥ 1 Gewichts-% bis ≤ 8 Gewichts-% aufweist.

4. Elektromechanischer Wandler gemäß einem der Ansprüche 1 bis 3, wobei die Komponente B) linear aufgebaut ist.

5. Elektromechanischer Wandler gemäß einem der Ansprüche 1 bis 4 mit einer maximalen Dehnung von ≥ 300% bis ≤ 450%.

6. Verfahren zur Herstellung eines elektromechanischen Wandlers, umfassend die Schritte:

1) Bereitstellen einer ersten Elektrode und einer zweiten Elektrode;
2) Bereitstellen eines dielektrischen Elastomers, wobei das dielektrische Elastomer ein Polyurethanpolymer umfasst, und das Polyurethanpolymer erhältlich ist aus der der Umsetzung von

A) Polyisocyanat und/oder NCO-terminiertes Prepolymer, wobei das NCO-terminierte Prepolymer ausgewählt aus mindestens einem aus der Gruppe bestehend aus

A1) NCO-terminiertes Prepolymer basierend auf Polyisocyanat und Polyetherpolyol, wobei das Polyetherpolyol eine Funktionalität von 2, eine OH-Zahl von 3 mg KOH/g bis 150 mg KOH/g und einen durch Gelpermeationschromatographie in Tetrahydrofuran (THF) mit Polystyrolstandards als Kalibrierbeziehung bestimmten Polydispersitätsindex $M_w/M_n$ von > 1,0 bis ≤ 1,2 aufweist,

A2) NCO-terminiertes Prepolymer basierend auf Polyisocyanat und Polyetherpolyol, wobei das Polyetherpolyol eine Funktionalität von >2 bis 8, eine OH-Zahl von 3 mg KOH/g bis 150 mg KOH/g und einen durch Gelpermeationschromatographie in Tetrahydrofuran (THF) mit Polystyrolstandards als Kalibrierbeziehung bestimmten Polydispersitätsindex $M_w/M_n$ von > 1,0 bis ≤ 1,2 aufweist,

A3) NCO-terminiertes Prepolymer mit Allophanat-, Biuret-, Isocyanurat-, Urethan-und/oder Harnstoff-Gruppen, basierend auf Polyisocyanat und Polyetherpolyol, wobei das Polyetherpolyol eine Funktionalität von 2, eine OH-Zahl von 3 mg KOH/g bis 150 mg KOH/g und einen durch Gelpermeationschromatographie in Tetrahydrofuran (THF) mit Polystyrolstandards als Kalibrierbeziehung bestimmten Polydispersitätsindex $M_w/M_n$ von > 1,0 bis ≤ 1,2 aufweist, und

A4) NCO-terminiertes Prepolymer mit Allophanat-, Biuret-, Isocyanurat-, Urethan-und/oder Harnstoff-Gruppen, basierend auf Polyisocyanat und Polyetherpolyol, wobei das Polyetherpolyol eine Funktionalität von >2 bis 8, einer OH-Zahl von 3 mg KOH/g bis 150 mg KOH/g und einen durch Gelpermeationschromatographie in Tetrahydrofuran (THF) mit Polystyrolstandards als Kalibrierbeziehung bestimmten Polydispersitätsindex $M_w/M_n$ von > 1,0 bis ≤ 1,2 aufweist,
mit

B) mindestens einer NCO-reaktiven Verbindung ausgewählt aus der Gruppe bestehend aus

B1) Polyetherpolyol mit einer Funktionalität von 2, einer OH-Zahl von 3 mg KOH/g bis 150 mg KOH/g und einen durch Gelpermeationschromatographie in Tetrahydrofuran (THF) mit Polystyrolstandards als Kalibrierbeziehung bestimmten Polydispersitätsindex $M_w/M_n$ von > 1,0 bis ≤ 1,2,

B2) Polyetherpolyol mit einer Funktionalität >2 bis 8, einer OH-Zahl von 3 mg KOH/g bis 150 mg KOH/g und einen durch Gelpermeationschromatographie in Tetrahydrofuran (THF) mit Polystyrolstandards als Kalibrierbeziehung bestimmten Polydispersitätsindex $M_w/M_n$ von > 1,0 bis ≤ 1,2,

B3) niedermolekulare, monomere Di-, Tri- und/oder Tetrole bzw. Di- und/oder Triamine,
wobei zur Herstellung der Komponente A) neben dem Polyetherpolyol keine weiteren gegenüber Isocyanaten reaktive Verbindungen eingesetzt werden;
wobei zur Herstellung des Polyurethanpolymers keine weiteren gegenüber Isocyanaten reaktive Verbindungen neben der Komponente B) eingesetzt werden, und
wobei mindestens eine der Komponenten A) und B) eine Funktionalität ≥ 3 aufweist, wobei A1) bzw. A2) nicht in Mischungen mit einer weiteren Komponente A) eingesetzt wird,
wobei B1) und/oder B2) nicht in Mischungen mit B3) eingesetzt werden,
wobei im Falle einer Umsetzung von A3) mit B1) und/oder B2) das Molekulargewicht des Polyetherpolyols enthalten im Prepolymer A3) gleich dem Molekulargewicht der Komponente B1) und/oder gleich dem Äquivalentgewicht der Komponente B2) ist,
wobei im Falle einer Umsetzung von A4) mit B1) und/oder B2) das Äquivalentgewicht des Polyetherpolyols enthalten im Prepolymer A4) gleich dem Molekulargewicht der Komponente B1) und/oder gleich dem Äquivalentgewicht der Komponente B2) ist,
wobei im Falle einer Umsetzung von einer Mischung aus A3) und A4) mit B1) und/oder B2) das Molekulargewicht des Polyetherpolyols enthalten im Prepolymer A3) gleich dem Äquivalentgewicht des Polyetherpolyols enthalten im Prepolymer A4) gleich dem Molekulargewicht der Komponente B1) und/oder gleich dem Äquivalentgewicht der Komponente B2) ist.

3) Anordnen des dielektrischen Elastomers zwischen die erste Elektrode und die zweite Elektrode.

**7.** Verfahren gemäß Anspruch 6, wobei das Polyisocyanat zur Herstellung des Prepolymers A) 1,6-Hexanmethylendiisocyanat ist.

**8.** Verfahren gemäß Anspruch 6 oder 7, wobei das Prepolymer A) einen NCO-Gehalt von ≥ 1 Gewichts-% bis ≤ 8 Gewichts-% aufweist.

**9.** Verfahren gemäß einem der Ansprüche 6 bis 8, wobei die Komponente B) linear aufgebaut ist.

**10.** Elektrische und/oder elektronische Vorrichtung, umfassend einen elektromechanischen Wandler gemäß einem der Ansprüche 1 bis 5.

**Europäisches Patentamt**
**European Patent Office**
**Office européen des brevets**

## EUROPÄISCHER RECHERCHENBERICHT

**Nummer der Anmeldung**

EP 11 16 1977

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X,D | WO 2008/095621 A1 (BAYER MATERIALSCIENCE AG [DE]; JENNINGER WERNER [DE]; KOEHLER BURKHARD) 14. August 2008 (2008-08-14) * Seite 3, Zeile 10 - Seite 4, Zeile 3; Ansprüche 1-6,8,9; Beispiel 2 * ----- | 1-10 | INV. C08G18/10 C08G18/48 C08G18/78 H01L41/193 H01L41/26 |
| X | EP 2 280 034 A1 (BAYER MATERIALSCIENCE AG [DE]) 2. Februar 2011 (2011-02-02) * Absätze [0044], [0046], [0047]; Beispiele V3, V5; Tabelle 1 * ----- | 1-10 | |
| X,D | KIM I ET AL: "Polymerization of propylene oxide by using double metal cyanide catalysts and the application to polyurethane elastomer", POLYMER, ELSEVIER SCIENCE PUBLISHERS B.V, GB, Bd. 44, Nr. 11, 1. Mai 2003 (2003-05-01), Seiten 3417-3428, XP004423214, ISSN: 0032-3861, DOI: 10.1016/S0032-3861(03)00226-X * Seite 3427, linke Spalte; Tabellen 3,5 * ----- | 1-10 | |
| | | | RECHERCHIERTE SACHGEBIETE (IPC) C08G H01L |

Der vorliegende Recherchenbericht wurde für alle Patentansprüche erstellt

| Recherchenort | Abschlußdatum der Recherche | Prüfer |
|---|---|---|
| München | 26. September 2011 | Krätzschmar, Ulrike |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

            ...........................................................................................
& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 11 16 1977

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

26-09-2011

| Im Recherchenbericht angeführtes Patentdokument | Datum der Veröffentlichung | Mitglied(er) der Patentfamilie | Datum der Veröffentlichung |
|---|---|---|---|
| WO 2008095621 A1 | 14-08-2008 | CA 2677393 A1<br>CN 101605845 A<br>DE 102007005960 A1<br>EP 2118190 A1<br>JP 2010518200 A<br>KR 20090116736 A<br>US 2008188615 A1<br>US 2010022706 A1 | 14-08-2008<br>16-12-2009<br>14-08-2008<br>18-11-2009<br>27-05-2010<br>11-11-2009<br>07-08-2008<br>28-01-2010 |
| EP 2280034 A1 | 02-02-2011 | WO 2011012244 A1 | 03-02-2011 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2001006575 A1
- WO 2008095621 A1
- WO 2009074192 A
- WO 9206139 A1
- EP 0573206 A1
- EP 1525244 A
- EP 700949 A

**In der Beschreibung aufgeführte Nicht-Patentliteratur**

- **IL KIM et al.** Polymer. Elsevier Science Publishers, 2003, vol. 44, 3417-3428